(19) Europäisches Patentamt
European Patent Office
Office européen des brevets

(11) EP 3 762 732 B1

(12) **EUROPÄISCHE PATENTSCHRIFT**

(45) Veröffentlichungstag und Bekanntmachung des Hinweises auf die Patenterteilung:
**04.05.2022 Patentblatt 2022/18**

(21) Anmeldenummer: **19710631.3**

(22) Anmeldetag: **06.03.2019**

(51) Internationale Patentklassifikation (IPC):
***G01R 33/46*** *(2006.01)*

(52) Gemeinsame Patentklassifikation (CPC):
**G01R 33/46;** G01R 33/4625

(86) Internationale Anmeldenummer:
**PCT/EP2019/055520**

(87) Internationale Veröffentlichungsnummer:
**WO 2019/170717 (12.09.2019 Gazette 2019/37)**

(54) **VERFAHREN ZUR HETERONUKLEAREN QUANTITATIVEN BESTIMMUNG MITTELS NMR-SPEKTROSKOPIE UND VERFAHREN ZUR BESTIMMUNG DES DEUTERIERUNGSGRADES EINER DEUTERIERTEN VERBINDUNG**

METHOD FOR HETERONUCLEAR QUANTITATIVE DETERMINATION USING NMR-SPECTROSCOPY AND METHOD FOR DETERMINING THE DEGREE OF DEUTERATION OF A DEUTERATED COMPOUND

PROCÉDÉ DE DÉTERMINATION QUANTITATIVE HÉTÉRONUCLÉAIRE AU MOYEN D'UNE SPECTROSCOPIE RMN ET PROCÉDÉ DE DÉTERMINATION DU DEGRÉ DE DEUTÉRISATION D'UN COMPOSÉ DEUTÉRÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.03.2018 DE 102018203434**

(43) Veröffentlichungstag der Anmeldung:
**13.01.2021 Patentblatt 2021/02**

(73) Patentinhaber: **Bruker BioSpin GmbH**
**76275 Ettlingen (DE)**

(72) Erfinder: **DIEHL, Bernd Willi Karl-Heinz**
**50678 Köln (DE)**

(74) Vertreter: **Winter, Brandl - Partnerschaft mbB**
**Alois-Steinecker-Straße 22**
**85354 Freising (DE)**

(56) Entgegenhaltungen:
**DE-A1-102012 204 701**

- **SANTOSH KUMAR BHARTI ET AL: "Quantitative 1H NMR spectroscopy", TRAC TRENDS IN ANALYTICAL CHEMISTRY, Bd. 35, Mai 2012 (2012-05), Seiten 5-26, XP055167863, ISSN: 0165-9936, DOI: 10.1016/j.trac.2012.02.007**
- **L. POHL ET AL: "Sodium 3-Trimethylsilyltetradeuteriopropionate, a New Water-Soluble Standard for 1H-NMR", ANGEWANDTE CHEMIE. INTERNATIONAL EDITION, Bd. 8, Nr. 5, Mai 1969 (1969-05), Seiten 381-381, XP055612427, DE ISSN: 0570-0833, DOI: 10.1002/anie.196903811**
- **Bernd W.K. Diehl ET AL: "Quantitative NMR spectroscopy in the quality evaluation of active pharmaceutical ingredients and excipients", Spectroscopy Europe Asia, Oktober 2007 (2007-10), Seiten 1-10, XP055612584, Internet Gefunden im Internet: URL:https://www.spectroscopyeurope.com/article/quantitative-nmr-spectroscopy-quality-evaluation-active-pharmaceutical-ingredients-and [gefunden am 2019-08-13]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 762 732 B1

## Beschreibung

Die vorliegende Erfindung betrifft ein Verfahren zur quantitativen Bestimmung eines Analyten in einem Prüfgegenstand unter Verwendung eines NMR-Spektrometers, wobei das zum Lösen des Analyten verwendete deuterierte Lösungsmittel als interner Standard verwendet wird, und ein Verfahren zur Bestimmung des Deuterierungsgrades einer deuterierten Verbindung.

Die Kernspinresonanzspektroskopie, im Folgenden auch NMR-Spektroskopie genannt, ist eines der grundlegenden Verfahren zur Strukturaufklärung von organischen Verbindungen. Es basiert darauf, dass die Atomkerne einer Vielzahl von Elementen einen Kernspin verschieden von Null aufweisen und der daraus resultierende Drehimpuls bei einem angelegten externen Magnetfeld Aussagen über die chemische Umgebung des Atoms gestattet.

Atome mit einem Kernspin von Null (I = 0), wie beispielsweise $^{12}C$ oder $^{16}O$, lassen sich mittels der NMR-Spektroskopie nicht erfassen. Demgegenüber sind alle Atome mit einem Kernspin verschieden von Null der NMR-Spektroskopie zugänglich. Am vorteilhaftesten weist der Kernspin I den Wert 1/2 auf, da dann lediglich zwei mögliche Eigenzustände, m = +1/2 und m = -1/2, existieren. Die Anzahl der möglichen Zustande errechnet sich nach der Formel: 2I + 1. Bei der Anwendung der NMR-Spektroskopie in der organischen Chemie kommen somit vor allem die Kerne $^{1}H$, $^{13}C$, $^{15}N$, $^{19}F$, $^{29}Si$, $^{31}P$ und $^{77}Se$ in Frage.

Neben der reinen Strukturaufklärung kann die NMR-Spektroskopie auch zur quantitativen Bestimmung einer zu untersuchenden Verbindung, d.h. eines Analyten, eingesetzt werden. Bei der quantitativen NMR-Spektroskopie wird aus einem Vergleich der Signalintensitäten des Analyten und einer gleichzeitig gemessenen Referenzsubstanz die in der Probenlösung enthaltene Menge an Analyt berechnet. In der Regel wird als Referenzsubstanz ein interner Standard der Probenlösung zugegeben, dessen Reinheit bekannt ist und dessen Signale sich möglichst nicht mit denen des Analyten überlagern. Die Referenzsubstanz kann auch als externer Standard verwendet werden. Im Folgenden wird eine in der NMR-Spektroskopie verwendete Referenzsubstanz auch als "Standard" bezeichnet.

Bei der quantitativen Auswertung eines NMR-Spektrums werden getrennt die Signale des Analyten und der Referenzsubstanz integriert. Dabei wird davon ausgegangen, dass jedes Atom, dessen Signale im Spektrum erscheinen, einen gleichgroßen Anteil an den Integralen der Signale beiträgt, so dass die Zahl der Atome proportional zu den Integralen, d.h. den Integralflächen, ist. Aus dem Verhältnis der Integrale und unter Berücksichtigung der Massen und Molmassen von Analyt und Referenzsubstanz und der Anzahl der Atome deren Signale integriert wurden, kann die Masse des in der Probenlösung enthaltenen Analyten berechnet werden.

Im Gegensatz zu anderen chromatographischen Verfahren muss bei der quantitativen NMR-Spektroskopie die als Standard verwendete Referenzsubstanz nicht mit dem zu bestimmenden Analyten identisch sein. Analyt und Standard müssen lediglich dieselbe Atomart (dasselbe Nuklid) enthalten, deren Signale auch bei dem NMR-Experiment erfasst werden. Das ermöglicht die Verwendung eines wie oben genannten internen Standards, wobei dieser interne Standard idealerweise so gewählt wird, dass dessen Signale im NMR-Spektrum sich nicht mit den Signalen des Analyten überlappen. Dabei werden Analyt und Standard in jeweils definierten Mengen (bestimmt durch Abmessen oder Abwiegen) in einer ausreichenden Menge eines meist deuterierten Lösungsmittels gelöst und dann im NMR-Spektrometer gemessen. Die genaue Menge an verwendetem Lösungsmittel muss bei diesem Verfahren nicht bekannt sein.

Für jeden zu untersuchenden Kern gibt es mehr oder weniger geeignete Standards (Standardsubstanzen) die in der Regel als genau definierte Standardlösungen vorgehalten werden. Sollen bei derselben Probe zusätzlich weitere Nuklidarten gemessen werden, so sind dazu bisher weitere Standards zuzusetzen, was aufwändig ist, da genau definierte Standardlösungen hergestellt und genau zudosiert werden müssen. Diese weiteren Standardlösungen müssen darüber hinaus auch regelmäßig auf ihre Reinheit kontrolliert werden, was einen zusätzlichen Aufwand darstellt.

Um die Anzahl an verschiedenen Standards und den Arbeitsaufwand zu verringern und einen universellen Standard für die wichtigsten NMR-aktiven Nuklide von organischen Molekülen bereitzustellen wurde in der DE 10 2012 204 701 A1 ein Multikernstandard vorgeschlagen, der neben Kohlenstoff- und Wasserstoffatomen auch Phosphor-, Stickstoff- und Fluoratome enthält. Durch Verwendung eines einzigen Standards können bei derselben Probe ohne weiteres Zutun mehrere Nuklidarten gemessen werden. Ein weiterer Vorteil des Multikernstandards ist die Tatsache, dass alle in ihm vorhandenen Arten von Atomen immer in exakten stöchiometrischen Verhältnissen vorhanden sind, so dass es zu keinen Wägefehlern kommen kann, wenn man das Verhältnis der Atome im Standard festlegen will.

Ist jedoch auch eine Messung weiterer aktiver Kerne, vor allem aus dem Bereich der anorganischen Anionen und Kationen wie beispielsweise Natrium (Na), Kalium (K), Chlor (Cl), Brom (Br) oder Aluminium (Al) gewünscht, so stehen keine geeigneten Substanzen zur Verwendung als Standard zur Verfügung. Na liegt lediglich als einfaches Kation vor, ebenso K oder Ca. Die Spezien Iod (I), Br und Cl sind nur als Anionen in wässriger oder organischer Lösung stabil. Lediglich Cl kann prinzipiell in Form eines Perchlorats als interner Standard verwendet werden. Demgegenüber ist Periodat zu reaktiv in Gegenwart von zu bestimmendem Iodid und kann daher nur als externer Standard eingesetzt werden, was entsprechende Nachteile mit sich bringt. So müssen Kalibriergeraden erstellt werden, was zu vielen langwierigen Referenzmessungen führt. Ein weiteres prinzipielles Problem bei der externen Kalibrierung in der NMR Spektroskopie besteht darin, dass keine Messzellen mit definiertem Volumen verfügbar sind. Solche werden vergleichsweise

etwa in der HPLC Chromatographie bei einer UV Detektion verwendet, bei der entweder eine permanent vorhandene Messzelle oder für einen Wechsel genormte Küvetten eingesetzt werden. Das Volumen der im Handel erhältlichen NMR-Messröhrchen ist nicht genormt und ergibt, je nach Qualität, einen Fehler von 0,5 bis 10 %. Alternativ könnte man für jede Messung dasselbe Röhrchen verwenden, was jedoch zu aufwändigem Spülen und Qualitätsuntersuchungen führt und insbesondere bei Reihen- und Routinemessungen nicht praktikabel ist.

Bei allen Versuchen in der Vergangenheit, diese Unzulänglichkeiten zu überwinden, war bei derartigen quantitativen Bestimmungen mindestens eine zweite Messung mit hohem Unsicherheitsfaktor nötig. Bei dem ERETIC-Verfahren (electronic reference to access in vivo concentrations) wurde versucht, ein eingestrahltes elektronisches Referenzsignal zur Quantifizierung zu verwenden. Dies scheiterte jedoch am Problem der Volumenvariation. Auch mit dem PULCON-Verfahren (pulse length based concentration determination) konnten keine genaueren Ergebnisse erhalten werden, als die Standardabweichung des mittleren Volumens der NMR-Röhrchen zulässt. Ein zweites Problem besteht darin, dass jedes NMR-Röhrchen individuell hinsichtlich der Empfindlichkeit abgestimmt werden muss, das sogenannte "Tuning and Matching". Volumenvariation und Abstimmung bewirken eine große Messunsicherheit.

Ein umfassender Überblick über die Grundkonzepte des quantitativen NMR-Spektroskopie und die dabei relevanten Parameter wird zudem von Santosh Kumar Bharti und Raja Roy in "Quantitative 1H NMR spectroscopy", Trends in Analytical Chemisrty, Vol. 35, 2012, S. 5-26, gegeben. In diesem Übersichtsartikel werden die neuesten Referenzierungstechniken für die quantitative Analyse, einschließlich Kalibrierungskurven- und Standardadditionsverfahren beschrieben.

Es ist daher die Aufgabe der vorliegenden Erfindung, die oben dargelegte Unzulänglichkeiten bei der quantitativen NMR-Spektroskopie zu überwinden und ein Kernspinresonanzspektroskopieverfahren, d.h., ein NMR-spektroskopisches Verfahren, bereitzustellen mit dem alle NMR-aktiven Nuklide auf einfache und dennoch genaue Weise quantitativ bestimmt werden können. Darüber hinaus werden notwendige definierte Referenzsubstanzen zur Verwendung in dem NMR-spektroskopischen Verfahren vorgestellt.

Gelöst wird diese Aufgabe mit dem wie im Anspruch 1 definierten Verfahren zur quantitativen Bestimmung eines Analyten in einem Prüfgegenstand unter Verwendung eines NMR-Spektrometers. Das erfindungsgemäße Verfahren weist die Schritte auf:

Bereitstellen einer Probenlösung durch Lösen einer definierten Menge des Prüfgegenstands in einer definierten Menge eines deuterierten Lösungsmittels, Kalibrieren des NMR-Spektrometers durch Bestimmen eines Kalibrierfaktors bezogen auf ein erstes und ein zweites NMR-aktives Nuklid, wobei das erste NMR-aktive Nuklid Bestandteil des deuterierten Lösungsmittels ist und das zweite NMR-aktive Nuklid Bestandteil des Analyten ist;

Erstellen eines ersten Spektrums durch Durchführen eines ersten NMR-Experiments an der Probenlösung zur Bestimmung der Resonanzfrequenzen des ersten NMR-aktiven Nuklids;

Erstellen eines zweiten Spektrums durch Durchführen eines zweiten NMR-Experiments an der Probenlösung zur Bestimmung der Resonanzfrequenzen des zweiten NMR-aktiven Nuklids, und

Berechnen der Masse an Analyt in der Probenlösung unter Berücksichtigung der Signale im ersten und zweiten Spektrum und unter Berücksichtigung des Kalibrierfaktors,

wobei das erste NMR-aktive Nuklid und das zweite NMR-aktive Nuklid voneinander verschieden sind,

der Kalibrierfaktor bestimmt wird durch Bestimmen der Resonanzfrequenzen des ersten NMR-aktiven Nuklids und des zweiten NMR-aktiven Nuklids in einer Kalibrierlösung, die bekannte Mengen des ersten NMR-aktiven Nuklids und des zweiten NMR-aktiven Nuklids enthält, Erstellen zweier Kalibrierspektren und Vergleich der Signale des ersten NMR-aktiven Nuklids und des zweiten NMR-aktiven Nuklids in den Kalibrierspektren und

das erste und das zweite NMR-Experiment und die Bestimmung des Kalibrierfaktors unter Verwendung desselben NMR-Spektrometers durchgeführt werden.

Die vorliegende Erfindung basiert auf der Erkenntnis der Erfinder, dass bei der quantitativen NMR-Spektroskopie das zur Herstellung der Probenlösung verwendete deuterierte Lösungsmittel auch als interner Standard verwendet werden kann und damit alle NMR-aktiven Nuklide in der Probenlösung quantitativ bestimmt werden können. Somit kann mit dem erfindungsgemäßen Verfahren auch ein Nuklid quantitativ erfasst werden, das nicht Bestandteil des verwendeten Standards ist. Im Folgenden wird dieser Ansatz auch "heteronukleare quantitative Bestimmung" oder "heteronukleare Quantifizierung" genannt.

Charakteristisch für das erfindungsgemäße Verfahren ist daher, dass das erste NMR-aktive Nuklid und das

zweite NMR-aktive Nuklid voneinander verschieden sind. Die Bezeichnung "erstes" bzw. "zweites" NMR-aktives Nuklid dient lediglich dazu, dass zwischen den beiden verschiedenen NMR-aktives Nukliden unterschieden werden kann.

Damit steht die vorliegende Erfindung im Gegensatz zu der üblichen Praxis der quantitativen NMR-Spektroskopie, bei der sowohl bei dem verwendeten Standard als auch dem zu bestimmenden Analyten dasselbe Nuklid quantitativ erfasst wird. Zur Unterscheidung kann die übliche quantitative NMR-Spektroskopie daher als "homonukleare quantitative Bestimmung" oder "homonukleare Quantifizierung" bezeichnet werden.

NMR-aktive Nuklide im Sinne dieser Anmeldung sind alle Nuklide, d.h. Atomkerne mononuklider Elemente oder unterschiedliche Isotope eines Elements, die einen Kernspin verschieden von Null aufweisen und somit NMR-spektroskopisch erfassbar sind.

Das erfindungsgemäße Verfahren dient dazu, den Anteil einer bestimmten Substanz (Analyt) in einem Gemisch aus mehreren Substanzen (Prüfgegenstand) zu bestimmen.

Um bei dem erfindungsgemäßen Verfahren eine quantitative Aussage treffen zu können, muss bei der Herstellung der zu vermessenden Probenlösung eine definierte Menge des Prüfgegenstands in einer definierten Menge eines deuterierten Lösungsmittels gelöst werden. Die definierten Mengen an Prüfgegenstand und deuteriertem Lösungsmittel können unabhängig voneinander durch Abmessen eines gewünschten Volumens oder Abwiegen einer gewünschten Masse erhalten werden. Es ist somit bekannt, welche Massen an Prüfgegenstand und deuteriertem Lösungsmittel in der Probenlösung enthalten sind.

Unter der Angabe, dass der Prüfgegenstand in dem deuterierten Lösungsmittel gelöst wird ist zu verstehen, dass der Prüfgegenstand vorzugsweise vollständig in dem Lösungsmittel gelöst wird. Es ist allerdings auch ausreichend, dass lediglich der im Prüfgegenstand enthaltene Analyt vollständig gelöst wird.

Die Probenlösung wird vorzugsweise in einem geeigneten Behälter zur Durchführung der NMR-Spektroskopie, wie einem NMR-Röhrchen, bereitgestellt.

Als deuterierte Lösungsmittel können vorzugsweise $D_2O$, DMSO-$d_6$, $CDCl_3$, Aceton-$d_6$, Acetonitril-$d_3$, Benzol-$d_6$ verwendet werden, wobei jedoch prinzipiell alle deuterierten Lösungsmittel verwendet werden können. Das verwendete deuterierte Lösungsmittel kann geeignet ausgewählt werden anhand verschiedener Parameter, wie beispielsweise der Löslichkeit des Prüfgegenstands bzw. des Analyten in dem Lösungsmittel oder einem inerten Verhalten des Lösungsmittels.

Bei dem erfindungsgemäßen Verfahren werden an der hergestellten Probenlösung zwei NMR-Experimente durchgeführt, bei denen getrennt Resonanzfrequenzen des ersten NMR-aktiven Nuklids und des zweiten NMR-aktiven Nuklids bestimmt und die Ergebnisse in entsprechenden NMR-Spektren dargestellt werden. Die Reihenfolge der Durchführung des ersten und des zweiten NMR-Experiments ist dabei prinzipiell gleichgültig. Die beiden NMR-Experimente müssen allerdings an derselben Probenlösung durchgeführt werden. Das heißt, das Verhältnis der Anteile an deuteriertem Lösungsmittel und Analyt in der Probenlösung darf sich zwischen den beiden NMR-Experimenten weder ändern noch darf es verändert werden. Nur dann kann eine quantitative Aussage hinsichtlich der Menge an Analyt im Prüfgegenstand getroffen werden.

Die Angabe, dass ein NMR-aktives Nuklid "Bestandteil des deuterierten Lösungsmittels ist" bedeutet, dass dieses Nuklid in der Summenformel des Lösungsmittels vertreten ist. Gleichermaßen bedeutet die Angabe, dass ein NMR-aktives Nuklid "Bestandteil des Analyten ist", dass dieses Nuklid in der Summenformel des Analyten vertreten ist. Wird als deuteriertes Lösungsmittel beispielsweise $D_2O$ verwendet, so ist beispielsweise Deuterium ($^2H$) Bestandteil des deuterierten Lösungsmittels. Ist der Analyt beispielsweise Ethanol ($C_2H_5OH$), so sind zum Beispiel Kohlenstoff (C) und Wasserstoff (H) jeweils Bestandteil des Analyten.

Damit ist jedoch nicht ausgeschlossen, das eines oder beide dieser Nuklide in beiden Summenformeln vertreten ist bzw. sind. Wird beispielsweise mit dem erfindungsgemäßen Verfahren eine quantitative Bestimmung einer organischen Kohlenwasserstoffverbindung unter Verwendung von Aceton-$d_6$ als deuteriertem Lösungsmittel durchgeführt, so ist Kohlenstoff (C) Bestandteil von sowohl dem deuterierten Lösungsmittel als auch dem Analyten.

Die beiden NMR-Experimente werden als solches auf übliche Weise durchgeführt und aus den Ergebnissen entsprechende NMR-Spektren erstellt, eines, in dem die Signale des NMR-aktiven Nuklids des als internen Standard verwendeten deuterierten Lösungsmittels dargestellt sind, und eines, in dem die Signale des NMR-aktiven Nuklids des Analyten dargestellt sind. So kann beispielsweise bei dem ersten NMR-Experiment ein $^2H$-NMR-Spektrum erstellt werden und kann beispielsweise bei dem zweiten NMR-Experiment ein $^1H$-NMR-Spektrum oder ein $^{13}C$-NMR-Spektrum erstellt werden.

Bei der üblichen homonuklearen quantitativen Bestimmung wird demgegenüber nur ein einzelnes NMR-Experiment durchgeführt und nur ein einzelnes Spektrum erhalten, in dem sowohl die Signale des internen Standards als auch die des Analyten dargestellt sind.

Für die quantitative Bestimmung des Analyten im Prüfgegenstand werden bei dem erfindungsgemäßen Verfahren somit Messergebnisse aus zwei unterschiedlichen NMR-Experimenten herangezogen. Die beiden NMR-Experimente unterscheiden sich darin, dass die Resonanzen unterschiedlicher Nuklide bei unterschiedlichen Resonanzfrequenzen ermittelt werden. Für eine quantitative Aussage können die dabei erhaltenen Messergebnisse, das heißt die

Integrale von Signalen aus verschiedenen Spektren, nicht direkt verglichen werden, was nachfolgend erläutert wird.

Ein der Quantenphysik geschuldetes Phänomen sind unterschiedliche Empfindlichkeiten der verschiedenen Kerne aufgrund der unterschiedlichen Resonanzfrequenzen bei gleicher magnetischer Feldstärke. Dieser Effekt wird quantifiziert durch das gyromagnetische Verhältnis y der NMR-spektroskopisch erfassten Nuklide und in der Form von Sensitivitätswerten ausgedrückt. Diese Werte sind allgemein bekannt. Beispielsweise ist $^{1}H$ das empfindlichste Nuklid. Das nächst empfindlichere Nuklid ist $^{19}F$, welches bereits 17 % weniger empfindlich als $^{1}H$ ist. Die Sensitivität von $^{2}H$ beträgt im Vergleich zu $^{1}H$ bereits nur noch ca. 1 % ($9,65 \times 10^{-3}$).

Insofern die untersuchten NMR-aktiven Nuklide nicht die einzigen natürlich vorkommenden Isotope dieses Elements sind, spielt auch die relative Häufigkeit des untersuchten Nuklids im natürlich vorkommenden Isotopengemisch eine Rolle. Dieser Faktor wird bei der Rezeptivität berücksichtigt, welche das Produkt aus Sensitivität und natürlicher Häufigkeit des Nuklids ist. Die Kerne $^{31}P$, $^{19}F$ und $^{23}Na$ liegen beispielsweise zu 100 % monoisotopisch vor. $^{1}H$ kann ohne nennenswertem Fehler auch als monoisotopisch angesehen werden. Demgegenüber müssen bei beispielsweise den Kernen $^{15}N$ und $^{13}C$ deren natürliche Häufigkeiten berücksichtigt werden. Diese Werte sind allgemein bekannt.

Die bei dem erfindungsgemäßen Verfahren als interner Standard verwendeten deuterierten Lösungsmittel sind in Bezug auf den Deuteriumanteil üblicherweise hoch angereichert mit Deuterierungsgraden von zwischen 99,5 % und 99,99 %, d.h. nahezu 100 %. Alternativ lässt sich der Deuterierungsgrad des verwendeten Lösungsmittels unter Anwendung des erfindungsgemäßen Verfahrens aus einem Vergleich des $^{1}H$ mit dem $^{2}H$-Signal (und bei Kenntnis des entsprechenden Kalibrierfaktors) leicht, schnell und sicher bestimmen.

Wenn bei dem ersten NMR-Experiment ein $^{2}H$-NMR-Spektrum erstellt wird, beträgt bei einem Deuterierungsgrad von ca. 100 % die Rezeptivität bei der Messung der NMR-Signale von $^{2}H$, bezogen auf eine Messung der NMR-Signale von $^{1}H$ somit ca. $9,65 \times 10^{-3}$.

Zusätzlich zu den oben genannten quantenmechanischen und chemischen Faktoren erschwert auch ein gerätespezifischer Faktor einen direkten Vergleich der Messergebnisse aus verschiedenen NMR-Experimenten. Dieser ist durch die Geometrie der Messapparatur bedingt und für jedes NMR-Spektrometer spezifisch aber individuell, auch wenn unterschiedliche Geräte derselben Bauart verglichen werden. So zeigte sich, dass die Spulengeometrie und andere Hardwareparameter eines Spektrometers einen erkennbaren Einfluss ausüben. Der gerätespezifische Faktor muss daher empirisch für jedes NMR-Spektrometer bestimmt werden, was nicht sehr aufwändig ist. Er bleibt konstant, solange keine Veränderungen an der Messapparatur vorgenommen werden. Die Bestimmung des gerätespezifischen Faktors kann im Rahmen eines Systemeignungstests (System Suitability Test (SST)) durchgeführt werden.

Um den gerätespezifischen Faktor zu berücksichtigen, ist es notwendig, das bei dem erfindungsgemäßen Verfahren verwendete NMR-Spektroskop zu kalibrieren. Zu diesem Zweck wird für jedes NMR-Spektrometer und für jedes Nuklidpaar, bestehend aus erstem NMR-aktiven Nuklid und zweitem NMR-aktiven Nuklid, ein Kalibrierfaktor bestimmt.

Im Speziellen kann der Kalibrierfaktor folgendermaßen bestimmt werden. Zuerst wird eine geeignete Kalibrierlösung hergestellt. Diese enthält bekannte Mengen des ersten NMR-aktiven Nuklids und des zweiten NMR-aktiven Nuklids. Zur Bestimmung eines Kalibrierfaktors für das Nuklidpaar $^{1}H$, $^{2}H$ wäre beispielsweise eine Lösung von $H_2O$ in $D_2O$ geeignet von der die genauen Mengen an darin enthaltenem $H_2O$ und $D_2O$ bekannt sind.

Mittels des zu kalibrierenden NMR-Spektrometers werden dann von der Kalibrierlösung ein $^{1}H$-NMR-Spektrum und ein $^{2}H$-NMR-Spektrum erstellt.

Durch einen Vergleich der Integrale der jeweiligen Peaks in den beiden Spektren und unter Berücksichtigung der bekannten Mengen an $H_2O$ und $D_2O$ in der Kalibrierlösung lässt sich nun der für dieses NMR-Spektrometer und dieses Nuklidpaar spezifische Kalibrierfaktor errechnen.

Das Verfahren zur Bestimmung der Kalibrierfaktoren zwischen D und allen anderen aktiven Kernen X kann durch die Verwendung speziell synthetisierter Verbindungen weiter vereinfacht werden. Diese Verbindungen enthalten beide Kerne D und X in durch die Natur der chemischen Struktur der Verbindungen in definierter Anzahl und somit in definierten molaren Verhältnissen. Da die Verhältnisse bekannt sind entfällt eine Einwaage. Eine Addition (Zugabe) einer solchen Referenzsubstanz kann in beliebiger Menge zur Analysenlösung aus eingewogener Probe und deuteriertem Lösungsmittel erfolgen. Aus dem Verhältnis der absoluten Integrale der spezifischen Signale für D und X wird der Kalibrierfaktor in jeder individuellen Messung ab initio bestimmt. Beispielhafte geeignete chemische Verbindungen, wie Isobutanol-d6, sind weiter untern aufgeführt.

Dieser Kalibrierfaktor berücksichtigt nicht nur den gerätespezifischen Faktor des verwendeten NMR-Spektrometers sondern auch die oben genannten chemischen und quantenmechanischen Faktoren des verwendeten Nuklidpaars. Da der Kalibrierfaktor auch gerätespezifische Eigenschaften berücksichtigt, müssen bei dem erfindungsgemäßen Verfahren das erste und das zweite NMR-Experiment und die Bestimmung des Kalibrierfaktors unter Verwendung desselben NMR-Spektrometers durchgeführt werden.

Somit wird in der vorliegenden Anmeldung auch ein Verfahren zum Kalibrieren eines NMR-Spektrometers zur Durchführung des erfindungsgemäßen Verfahrens der heteronuklearen quantitativen Bestimmung offenbart.

Das Kalibrieren des NMR-Spektrometers kann sowohl vor dem Durchführen der ersten und zweiten NMR-Experimente als auch danach durchgeführt werden.

Schließlich wird bei dem erfindungsgemäßen Verfahren die Masse an in der Probenlösung enthaltenem Analyt unter Berücksichtigung der Signale im ersten und zweiten Spektrum und unter Berücksichtigung des Kalibrierfaktors berechnet. Dies wird später ausführlich erläutert.

Bei dem erfindungsgemäßen Verfahren ist es bevorzugt, dass das NMR-aktive Nuklid, das Bestandteil des deuterierten Lösungsmittels ist und oben als das erste NMR-aktive Nuklid bezeichnet wird, $^2H$ (das Deuteriumisotop von Wasserstoff) ist.

Dabei macht man sich zu Nutze, dass das Deuteriumatom $^2H$ (oder D) einen Kernspin von 1 aufweist und somit NMR-spektroskopisch erfassbar ist. Somit kann jedes deuterierte Lösungsmittel als interner Standard verwendet werden. Dabei ist zu berücksichtigen, dass die Resonanzfrequenz von $^2H$ deutlich geringer ist als die von $^1H$ mit einem Frequenzverhältnis $\Xi$ von 15,40 % (in Relation zu der Protonenfrequenz bei 0 ppm von TMS (Tetramethylsilan) in $CDCl_3$).

Wie oben dargelegt, ist die Sensitivität von $^2H$ relativ gering und beträgt die Rezeptivität bei der Messung der NMR-Signale von $^2H$ bezogen auf eine Messung der NMR-Signale von $^1H$ lediglich ca. 1 % ($9{,}65 \times 10^{-3}$). Dies wird jedoch dadurch kompensiert, dass bei der NMR-Spektroskopie das Lösungsmittel in einem deutlichen Überschuss in der Probenlösung vorhanden ist.

Werden bei dem erfindungsgemäßen Verfahren das erste und das zweite NMR-Experiment gepulst durchgeführt, so muss bei einem Vergleich der Signale aus den beiden Spektren zudem die Anzahl an Pulsen berücksichtigt werden mit der das erste und das zweite NMR-Experiment jeweils durchgeführt wurde (Dividieren der Integralwerte durch die Anzahl an Pulsen).

Der größte Vorteil wird bei dem erfindungsgemäßen Verfahren dadurch erhalten, dass das Lösungsmittel zugleich als Referenzstandard bzw. Referenzsubstanz und dabei sogar als interner Standard verwendet wird. Damit wird das Problem der eingangs erwähnten Volumenvariation bei den NMR-Röhrchen eliminiert. Da bei der NMR-Spektroskopie bereits üblicherweise ein Lösungsmittel verwendet wird, muss keine zusätzliche Substanz als Standard zugegeben werden. Das Lösungsmittel, das hier auch als Standard fungiert, muss lediglich genau abgemessen werden (beispielsweise durch Abmessen eines genauen Volumens oder Abwiegen einer genauen Masse). Dieser interne Standard, d.h. das Lösungsmittel, kann zudem gleichzeitig als Lock-Substanz fungieren, um die Frequenzstabilität zu verbessern. Eine bevorzugte Substanz ist hierbei beispielsweise $D_2O$. Somit fungiert der interne Standard gleichzeitig als Lösungsmittel und zusätzlich als Lock-Substanz.

Zudem genügt zum Kalibrieren der Messung, d.h. der Aufnahme des $^2H$-NMR-Spektrums, in der Regel ein einziger Impuls, was bei dem gesamten Messverfahren zu lediglich einer minimalen Verlängerung der Gesamtmesszeit von etwa 10 Sekunden führt.

Nachfolgend wird ausführlich dargelegt, wie anhand einer NMR-spektroskopischen Untersuchung eines Prüfgegenstands eine quantitative Aussage hinsichtlich einer im Prüfgegenstand enthaltenen Verbindung, dem Analyten, getroffen werden kann, sowohl für die bekannte homonukleare quantitative Bestimmung als auch für die erfindungsgemäße heteronukleare quantitative Bestimmung. Die dabei verwendeten Variablen und Konstanten sind in Tabelle 1 aufgelistet.

Tabelle1

| Variable/Konstante | Bedeutung |
|---|---|
| $m_{IS}$ | Masse (Einwaage) des internen Standards |
| $m_{PG}$ | Masse (Einwaage) des Prüfgegenstands |
| $M_{RS}$ | Molekulargewicht der Referenzsubstanz |
| $M_A$ | Molekulargewicht des Analyten |
| $n_{RS}$ | Stoffmenge der Referenzsubstanz |
| $n_A$ | Stoffmenge des Analyten |
| $w_{RS}$ | Massenanteil der Referenzsubstanz im internen Standard (Gew.-%) |
| $w_A$ | Massenanteil des Analyten im Prüfgegenstand (Gew.-%) |
| $I_{RS}$ | Integral des Peaks der Referenzsubstanz |
| $I_A$ | Integral des Peaks des Analyten |
| $ZA_{RS}$ | Anzahl der Atome des Peaks der Referenzsubstanz*) |
| $ZA_A$ | Anzahl der Atome des Peaks des Analyten*) |

(fortgesetzt)

| Variable/Konstante | Bedeutung |
|---|---|
| $NS_{RS}$ | Anzahl an Pulsen (number of scans) bei Aufnahme des Spektrums der Referenzsubstanz |
| $NS_A$ | Anzahl an Pulsen (number of scans) bei Aufnahme des Spektrums des Analyten |
| X, Y | NMR-aktive Nuklide deren Resonanzen gemessen werden (wie bsw. $^1H$, $^2H$; $^{13}C$, usw.) = Nuklidpaar |
| Faktor (X,Y) | Durch Kalibriermessungen vorab ermittelter gerätespezifischer Kalibrierfaktor, der eine Vergleichbarkeit der Integrale in den Spektren der Nuklide X und Y gestattet. |
| *) Bezeichnet die Anzahl der Atome des NMR-aktiven Nuklids die bei dem NMR-Spektrum den zur quantitativen Bestimmung verwendeten Peak hervorgerufen hat. | |

Berechnung bei der homonuklearen quantitativen Bestimmung:

Zur Herstellung einer geeigneten Probenlösung wird eine bekannte Masse des Prüfgegenstands $m_{PG}$ zusammen mit einer bekannten Masse des internen Standards mis eingewogen und in einem geeigneten Lösungsmittel gelöst. Der interne Standard kann beispielsweise flüssig, ein Feststoff oder eine Lösung in einem geeigneten Lösungsmittel sein und enthält die Referenzsubstanz in einem genau bekannten Anteil, dem Massenanteil $w_{RS}$.

Die Struktur der Referenzsubstanz ist bekannt. Die Struktur des Analyten im Prüfgegenstand ist üblicherweise ebenfalls bekannt bzw. kann anhand des NMR-Spektrums ermittelt werden. Somit können die in dem erhaltenen NMR-Spektrum sichtbaren einzelnen Signale/Peaks eindeutig der Referenzsubstanz bzw. dem Analyten zugeordnet werden.

Für sowohl die Referenzsubstanz als auch den Analyten werden bei je einem ausgewählten Peak die Integrale $I_{RS}$ bzw. $I_A$ bestimmt, die der Fläche unter den jeweiligen Peaks entsprechen. Zudem muss die Anzahl der Atomkerne bekannt sein, die die jeweiligen Peaks hervorgerufen haben. Bei der Verwendung von beispielsweise Dimethylsulfon als Referenzsubstanz wird dessen Peak in einem $^1H$-NMR-Spektrum von 6 H-Atomen hervorgerufen. Wird zur quantitativen Bestimmung des Analyten der Peak einer einzelnen $CH_3$-Gruppe herangezogen, so ist das Integral dieses Peaks das Ergebnis von 3 H-Atomen.

Mit der folgenden Formel (1) kann anhand der eingewogenen Masse mis an internem Standard, des Massenanteils $w_{RS}$ der Referenzsubstanz im internen Standard und deren Molmasse $M_{RS}$ die Stoffmenge $n_{RS}$ der Referenzsubstanz in der Probenlösung berechnet werden:

$$n_{RS}\,[\text{mmol}] = \frac{m_{IS}\,[\text{mg}] \times w_{RS}\,[\%]}{M_{RS}\,[\text{g/mol}] \times 100} \qquad (1)$$

Mit der folgenden Formel (2) kann über einen Vergleich der Integrale $I_A$ und $I_{RS}$ von je einem Peak des Analyten bzw. der Referenzsubstanz im internen Standard und unter Berücksichtigung der Zahl der Atome $ZA_A$ bzw. $ZA_{RS}$, die die Peaks hervorgerufen haben, die Stoffmenge $n_A$ des Analyten in der Probenlösung berechnet werden:

$$n_A\,[\text{mmol}] = \frac{I_A \times ZA_{RS} \times n_{RS}\,[\text{mmol}]}{I_{RS} \times ZA_A} \qquad (2)$$

Mit der folgenden Formel (3) kann anhand der Stoffmenge $n_A$ an Analyt in der Probenlösung, dessen Molmasse $M_A$ und der eingewogenen Masse $m_{PG}$ des Prüfgegenstands der Massenanteil $w_A$ des Analyten im Prüfgegenstand berechnet werden:

$$w_A\,[\%] = \frac{M_A\,[\text{g/mol}] * n_A\,[\text{mmol}] * 100}{m_{PG}\,[\text{mg}]} \qquad (3)$$

Berechnung bei der heteronuklearen quantitativen Bestimmung:

Zur Herstellung einer geeigneten Probenlösung wird eine bekannte Masse des Prüfgegenstands $m_{PG}$ zusammen mit einer bekannten Masse des deuterierten Lösungsmittels mis eingewogen und darin aufgelöst. Da das deuterierte Lösungsmittel als interner Standard verwendete wird ist es bei dem erfindungsgemäßen Verfahren nicht notwendig eine weitere Substanz der Probenlösung zuzugeben.

Von der Probenlösung werden vorzugsweise ein $^2$H-NMR-Spektrum (mit einer geeigneten Anzahl an Pulsen $NA_{RS}$) und zusätzlich ein weiteres NMR-Spektrum aufgenommen. Das weitere NMR-Spektrum ist üblicherweise ein für die Bestimmung des Analyten geeignetes NMR-Spektrum (mit einer geeigneten Anzahl an Pulsen $NA_A$), wie beispielsweise ein $^1$H- oder ein $^{13}$C-NMR-Spektrum.

Die Struktur des deuterierten Lösungsmittels, d.h. der Referenzsubstanz, ist naturgemäß bekannt. Die Struktur des Analyten ist üblicherweise ebenfalls bekannt bzw. kann anhand des NMR-Spektrums ermittelt werden. Somit können die in den erhaltenen NMR-Spektren sichtbaren einzelnen Signale/Peaks eindeutig der Referenzsubstanz bzw. dem Analyten zugeordnet werden.

Für die Referenzsubstanz wird in dem $^2$H-NMR-Spektrum bei einem ausgewählten Peak das Integral $I_{RS}$ bestimmt. Gleichermaßen wird in dem weiteren NMR-Spektrum bei einem ausgewählten Peak das Integral $I_A$ bestimmt. Wie bei der homonuklearen quantitativen Bestimmung muss die Anzahl der Atomkerne bekannt sein, die die jeweiligen Peaks hervorgerufen haben.

Mit der folgenden Formel (1) kann anhand der eingewogenen Masse mis an internem Standard, d.h. deuteriertem Lösungsmittel, des Massenanteils $w_{RS}$ der Referenzsubstanz im internen Standard und deren Molmasse $M_{RS}$ die Stoffmenge $n_{RS}$ der Referenzsubstanz in der Probenlösung berechnet werden:

$$n_{RS}\,[\text{mmol}] = \frac{m_{IS}\,[\text{mg}] \times w_{RS}\,[\%]}{M_{RS}\,[\text{g/mol}] \times 100} \qquad (1)$$

Der Massenanteil $w_{RS}$ der Referenzsubstanz ergibt sich aus der Reinheit und dem Deuterierungsgrad des deuterierten Lösungsmittels und ist für die handelsüblichen deuterierten Lösungsmittel bekannt.

Mit der folgenden Formel (2a) kann über einen Vergleich der Integrale $I_A$ und $I_{RS}$ von je einem Peak des Analyten bzw. der Referenzsubstanz im internen Standard und unter Berücksichtigung der Zahl der Atome $ZA_A$ bzw. $ZA_{RS}$, die die Peaks hervorgerufen haben, die Stoffmenge $n_A$ des Analyten in der Probenlösung berechnet werden:

$$n_A\,[\text{mmol}] = \frac{[I_A \times \text{Faktor}\,(X,Y) / NS_A] \times ZA_{RS} \times n_{RS}\,[\text{mmol}]}{[I_{RS} / NS_{RS}] \times ZA_A} \qquad (2a)$$

Da in den NMR-Spektren die Peakflächen (Integrale) mit zunehmender Zahl der Pulse zunehmen und von einer linearen Abhängigkeit ausgegangen werden kann, werden die Integrale $I_A$ und $I_{RS}$ in obiger Gleichung (2A) in Relation zu der Anzahl an Pulsen $NS_A$ bzw. $NS_{RS}$ (number of scans) gesetzt.

Ferner wird in der Gleichung (2a) der Faktor (X,Y) berücksichtigt, der durch eine Kalibriermessung ermittelt werden kann. X und Y bezeichnen hierbei die jeweiligen Kerne in der Probenlösung, die bei den beiden NMR-Spektren erfasst werden, wie beispielsweise $^2$H und $^1$H.

Mit der folgenden Formel (3) kann anhand der Stoffmenge $n_A$ an Analyt in der Probenlösung, dessen Molmasse $M_A$ und der eingewogenen Masse $m_{PG}$ des Prüfgegenstands der Massenanteil $w_A$ des Analyten im Prüfgegenstand berechnet werden:

$$w_A\,[\%] = \frac{M_A\,[\text{g/mol}] * n_A\,[\text{mmol}] * 100}{m_{PG}\,[\text{mg}]} \qquad (3)$$

Bei dem erfindungsgemäßen Verfahren müssen das erste und das zweite NMR-Experiment und die Bestimmung des Kalibrierfaktors unter Verwendung desselben NMR-Spektrometers durchgeführt werden. Vorzugsweise werden bei diesen Messungen auch all die Parameter der jeweiligen NMR-Experimente unverändert beibehalten, die einen Einfluss auf die Integrale der Peaks haben. Alternativ kann die Veränderung einiger dieser Parameter mathematisch berücksichtigt und korrigiert werden.

Ein entsprechender Parameter, mit dem die Umwandlung der Analogsignale in digitale Signale optimiert werden kann, ist der sogenannte RG (Receiver Gain, Signalverstärkung). Vorzugsweise wird dieser Parameter bei den NMR-Experimenten auf 1 gesetzt. Im Prinzip ist das zur Auswertung herangezogene Integral eine lineare Funktion von RG, so dass bei unterschiedlichen RGs mathematische Korrekturen möglich sind. Eine Korrektur bezüglich des RG muss dazu in obiger Gleichung 2a berücksichtigt werden.

Ein weiterer relevanter Parameter bei einem NMR-Experiment ist der Pulswinkel PW. Im ausrelaxierten Zustand ist die Summe der Z-Magnetisierung durch die Kernspins auf 1 normiert. Die Intensität der X,Y Magnetisierung ist eine Funktion der Dauer der Anregung, die normalerweise im Bereich von 10 bis 200 $\mu$sec liegt. Dabei wird der Z-Vektor auf eine Kreisbewegung gebracht. Der Vektor wird in Abhängigkeit von der Anregungsdauer auch Pulswinkel genannt. Die maximale Intensität der Anregung wird durch einen 90° Puls erreicht, 100 % der Z-Magnetisierung werden in X,Y Magnetisierung umgewandelt. Verdoppelt man die Anregungszeit so ergibt sich eine negative Z-Magnetisierung, die X,Y Magnetisierung ist 0. Dabei beschreibt die makroskopische Magnetisierung der angeregten Kernspins einen Einheitskreis. Im Vektorfeld ist dabei die Intensität in X,Y eine Sinusfunktion. Aus mathematisch ersichtlichen Gründen ist ein eventuell auftretender Fehler durch nicht exakte Pulswinkeleinstellungen bzw. Pulszeiten bei einem 90° Puls am geringsten. Daher ist bei der erfindungsgemäßen heteronuklearen Quantifizierung der 90° Puls bevorzugt. Anderenfalls müsste eine Korrektur der absoluten Integrale vorgenommen werden. Im homonuklearen Fall der Quantifizierung spielt der PW keine Rolle, da er mathematisch aus der Gleichung gekürzt wird.

Ein weiterer Parameter ist das sogenannte Relaxationsdelay D1. Es definiert die experimentelle Wartezeit zwischen zwei Pulsen (NS > 1) und muss daher auch nur für den Fall NS>1 berücksichtigt werden. Dieser Wert muss so groß sein, dass eine vollständige Relaxation beider gemessener Nuklide gewährleistet ist. Die Relaxationszeit ist eine Materialeigenschaft und somit individuell für alle Nuklide und auch innerhalb einer homonuklearen Gruppe in unterschiedlicher molekularer Umgebung. Dieser Parameter ist bei jeder Quantifizierung einzuhalten und kann nicht mathematisch berücksichtigt werden. Neben der klassischen T1 Messung gibt es einen einfachen Test durch einen einzelnen, dem NMR Experiment nachgestellten 90° Puls ohne ein D1, mit dem überprüft werden kann, ob das Relaxationsdelay D1 ausreichend groß war.

Mit dem erfindungsgemäßen Verfahren kann die NMR-Spektroskopie auf die Stufe einer primären quantitativen Messmethode gehoben werden und damit einer Wägung gleichgesetzt werden. Wie eine Waage muss ein NMR-Experiment lediglich kalibriert werden.

Auf dem Gebiet der Analytik ionischer pharmazeutischer Wirkstoffe können mit dem erfindungsgemäßen Verfahren beispielsweise mit einer einzigen NMR-spektroskopischen Analyse die zu analysierenden Anionen bzw. Kationen gleichzeitig qualitativ wie auch quantitative bestimmt werden.

Das der vorliegenden Erfindung zugrundeliegende Prinzip der Nutzung eines deuterierten Lösungsmittels als interner Standard ermöglicht zudem eine schnelle und einfache Bestimmung des Deuterierungsgrades einer deuterierten Verbindung.

Der Deuterierungsgrad einer Verbindung wird in der Regel in % angegeben und bezeichnet den Anteil der Wasserstoffatome in der Verbindung die durch ein Deuteriumatom ersetzt sind. Entsprechend lässt sich auch ein Protonierungsgrad definieren, wobei gilt: Deuterierungsgrad = 1 - Protonierungsgrad.

Erfindungsgemäß lässt sich somit auch ein Verfahren zur Bestimmung des Deuterierungsgrades einer ersten deuterierten Verbindung bereitstellen mit den Schritten:

Herstellen einer Mischung aus der ersten deuterierten Verbindung und einer zweiten deuterierten Verbindung deren Deuterierungsgrad bekannt ist, so dass beide deuterierten Verbindungen gelöst vorliegen;

Erstellen eines $^1$H-NMR-Spektrums von der Mischung und Bestimmen der Integrale von mindestens einem Peak von jeder der beiden deuterierten Verbindungen;

Erstellen eines $^2$H-NMR-Spektrums von der Mischung und Bestimmen der Integrale derselben Peaks;

Berechnen des Deuterierungsgrades der ersten deuterierten Verbindung anhand der bestimmten Integralwerte und dem bekannten Deuterierungsgrad der zweiten deuterierten Verbindung.

Gemäß einer bevorzugten Ausführungsform ist mindestens eine der ersten und zweiten deuterierten Verbindungen ein deuteriertes Lösungsmittel für die NMR-Spektroskopie.

Das Mischungsverhältnis der ersten und zweiten deuterierten Verbindung muss nicht genau bekannt sein solange aussagekräftige NMR-Spektren erhalten werden können. Bevorzugte gewichtsbezogene Mischungsverhältnisse liegen zwischen 1:99 bis 99:1, weiter bevorzugt zwischen 10:90 und 90:10 und besonders bevorzugt zwischen 30:70 bis 70:30. Am einfachsten und daher speziell bevorzugt werden die erste und zweite deuterierte Verbindung in einem Verhältnis von ungefähr 1:1 gemischt.

Aus den beiden Spektren werden von jeweils denselben Peaks der ersten und der zweiten Verbindungen die Integrale bestimmt und für jede der beiden Verbindungen ein Integralverhältnis D/H errechnet. Mit den berechneten Integralverhältnissen und unter Berücksichtigung des bekannten Protonierungsgrades der zweiten deuterierten Verbindung kann mittels der Gleichung (4) der Protonierungsgrad und daraus der Deuterierungsgrad der ersten deuterierten Verbindung berechnet werden.

$$\{D\}_{Vb1} = 100 - (\{H\}_{Vb2} \times (IntH_{Vb2} / IntD_{Vb2}) / (IntH_{Vb1} / IntD_{Vb1}) \qquad (4)$$

mit:

$\{D\}_{Vb1}$ = Deuterierungsgrad der ersten deuterierten Verbindung
$\{H\}_{Vb2}$ = Protonierungsgrad der zweiten deuterierten Verbindung
$IntH_{Vb1}$ = Integral eines Peaks der ersten deuterierten Verbindung im $^1$H-NMR-Spektrum
$IntD_{Vb1}$ = Integral desselben Peaks der ersten deuterierten Verbindung im $^2$H-NMR-Spektrum
$IntH_{Vb2}$ = Integral eines Peaks der zweiten deuterierten Verbindung im $^1$H-NMR-Spektrum
$IntD_{Vb2}$ = Integral desselben Peaks der zweiten deuterierten Verbindung im $^2$H-NMR-Spektrum

Der Vorteil dieses Verfahrens zur Bestimmung des Deuterierungsgrades liegt unter anderem darin, dass weder ein genaues Mischungsverhältnis bekannt sein muss, noch müssen die oben erwähnten quantenmechanischen, chemischen oder gerätespezifischen Faktoren bekannt sein. Mit dem Verfahren können insbesondere die Deuterierungsgrade von Lösungsmitteln für die NMR-Spektroskopie auf einfach Weise genau bestimmt werden.

Bei dem erfindungsgemäßen Verfahren zur heteronuklearen quantitativen Bestimmung mittels NMR-Spektroskopie ist, wie oben erwähnt, ein einmaliges Kalibrieren des verwendeten NMR-Spektrometers notwendig. Die hierzu notwendige Kalibrierlösung enthält bekannte Mengen des ersten NMR-aktiven Nuklids und des zweiten NMR-aktiven Nuklids und kann somit durch genaues Abmessen zweier geeigneter Verbindungen hergestellt werden.

Alternativ dazu kann für die Kalibrierung eine Verbindung verwendet werden, die in ihrer Strukturformel eine definierte Anzahl der beiden Nuklide enthält. Im Fall von beispielsweise $^1$H und $^2$H als die beiden Nuklide wäre eine geeignete Verbindung Isopropanol-$d_6$, $(CD_3)_2CHOH$, das durch Reduktion von Aceton-$d_6$ erhältlich ist. Da bei dieser Verbindung ein genau definiertes und gleichbleibendes Verhältnis der Nuklide $^2$H und $^1$H von 6:2 gegeben ist, fällt bei Verwendung dieser Verbindung als Referenzsubstanz die Notwendigkeit des genauen Abmessens weg.

Ausgehend davon sind weitere chemische Verbindungen denkbar, die neben einer definierten Anzahl an Deuteriumatomen zusätzlich ein oder mehrere weitere Nuklide enthalten, die NMR-spektroskopisch detektierbar sind, wie beispielsweise Kohlenstoff, Stickstoff, Phosphor, Fluor, Silicium, Bor, Selen etc. enthalten.

Beispiele derartiger Verbindungen, die als Referenzsubstanz bei der Kalibrierung verwendet werden können, sind Phosphorsäureestern von Isopropanol-d6:

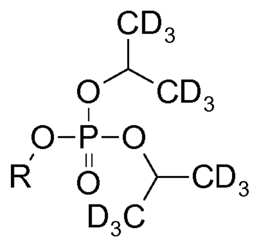

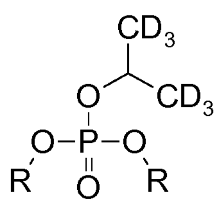

wobei der Phosphor auch andere Oxidationsstufen aufweisen kann (wie beispielsweise Phosphonsäureester).

Der Rest R kann so gewählt werden, dass damit andere NMR aktive Kerne, besonders Fluor, Silicium und Bor Bestandteil der Referenzsubstanz werden. Im Falle von R = Isopropyl-d6 ergibt sich eine Verbindung, die lediglich als Referenzsubstanz zur Kalibrierung bei der Bestimmung von Deuterium, Wasserstoff und Phosphor geeignet ist. Bei den

folgenden Verbindungen wurde der Rest R so gewählt, dass die Referenzsubstanz auch eine definierte Zahl an Fluoratomen enthält, so dass damit Referenzsubstanzen zugänglich sind, die auch zur Kalibrierung bei der Bestimmung von fluorhaltigen Verbindungen geeignet sind:

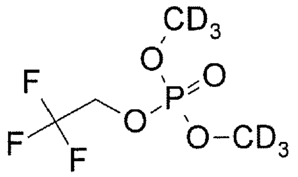

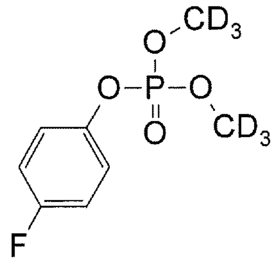

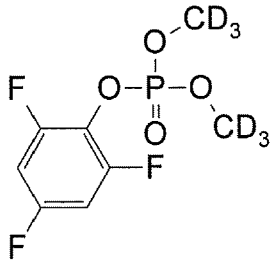

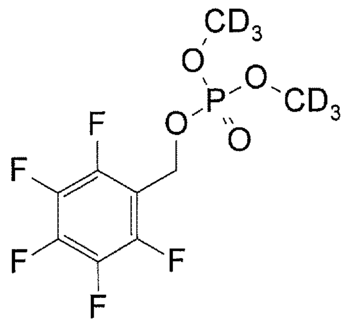

Basierend auf dem Prinzip des erfindungsgemäßen Verfahrens zur heteronuklearen quantitativen Bestimmung mittels NMR-Spektroskopie wird somit zudem die Verwendung derartiger oben beschriebener Verbindungen, d.h. Verbindungen, die in ihrer Strukturformel eine definierte Anzahl von Deuteriumatomen und eine definierte Anzahl von mindestens einem weiteren NMR-spektroskopisch erfassbaren Nuklid enthalten, zur Kalibrierung eines NMR-Spektroskops für die heteronukleare quantitative Bestimmung zur Verfügung gestellt.

Wie bereits dargelegt, wird in der vorliegenden Anmeldung auch ein Verfahren zum Kalibrieren eines NMR-Spektrometers zur Durchführung des erfindungsgemäßen Verfahrens der heteronuklearen quantitativen Bestimmung offenbart. Die oben beschriebenen Verbindungen können in einem derartigen Kalibrierverfahren verwendet werden.

Dabei ist es besonders bevorzugt, dass die als Referenzsubstanz verwendbare chemische Verbindung bei Raumtemperatur oder bei leicht erhöhter Temperatur flüssig ist. Dies ermöglicht eine einfachere Verwendung der Verbindung als Reinsubstanz.

Die quantitative heteronukleare NMR-Spektroskopie bezieht sich nun lediglich auf eine rein mathematische Grundlage, die auf die natürliche Stöchiometrie definierter organische Moleküle rückführbar ist. Man kann dieses System als Quantenwaage bezeichnen, somit als eine primäre absolute analytische Methode, die in ihrer Anwendung in der Praxis zu einer primären relativen Methode wird.

Mit dem erfindungsgemäßen Verfahren wird es möglich quantitative NMR-Spektroskopie ohne Zugabe einer wie bisher verwendeten speziellen Standardsubstanz durchzuführen.

Ein wichtiges Gebiet für eine derartige "standardfreie Analytik" bietet die Diagnostik bzw. Forensik. Die Verwendung des Lösungsmittels $D_2O$ als Referenz kann beispielsweise die Bestimmung des Blutalkohols gegenüber den herkömmlichen Methoden noch einmal deutlich verbessern. Hinsichtlich der Bestimmung der Blutalkoholkonzentration mittels NMR-Spektroskopie wird auf das Patent DE 10 2012 224 334 B4 verwiesen.

Das kombinierte $^1H/^2H$-NMR-Verfahren ermöglicht in Analogie zur oben dargelegten Bestimmung des Deuterierungsgrades von Lösungsmitteln die direkte Bestimmung des Wasseranteils in Blut- und Plasmaproben. Der Gehalt an Ethanol als Blutalkohol in einer Blutprobe kann somit ohne Notwendigkeit eines üblichen Standards direkt bestimmt werden und es ist lediglich eine Einfachbestimmung nötig.

Neben der quantitativen Bestimmung von Wasser und Blutalkohol im Blut werden durch das erfindungsgemäße Verfahren weitere wichtige Parameter der Blutzusammensetzung direkt zugänglich, d.h. können auf einfache Weise und genau quantitativ erfasst werden. Dazu gehören unter anderem Glucose, Milchsäure, spezielle Aminosäuren oder ADP/ATP. Auch die Signale der komplexen Lipoproteine, die ein eindeutiges Zeichen für die Identität von Humanblut darstellen, können erfasst werden und bilden einen spektroskopischen Fingerabdruck, der besonders in forensischen Proben die Identität und Quantität des untersuchten Materials als Humanblut bestätigen. Weitere Metaboliten können auf analoge Weise mittels geeigneter Messbedingungen erfasst werden, darunter die als Liquid Ecstasy bekannte gamma-Hydroxybuttersäure.

Weitere Vorteile und Merkmale der vorliegenden Erfindung ergeben sich anhand der Beschreibung von Ausführungsbeispielen sowie anhand der Zeichnungen, wobei:

Fig. 1 ein $^{2}H$ NMR-Spektrum von Na-Heparin in $D_2O$ zeigt;

Fig. 2 ein $^{23}Na$ NMR-Spektrum von Na-Heparin in $D_2O$ zeigt und

Fig. 3 ein $^{23}Na$ NMR-Spektrum mit verschiedener Konzentration an Na-Heparin zeigt.

Fig. 4 ein $^{1}H$-NMR Spektrum von DMSO-$d_6$ mit Ausschnittsvergrößerungen zeigt.

Fig. 5 ein $^{2}H$-NMR Spektrum von DMSO-$d_6$ (links) und in Vergrößerung eine Überlagerung mit dem entsprechenden $^{1}H$-NMR Spektrum aus Fig. 4 (rechts) zeigt.

Fig. 6 ein Diagramm zur Bestimmung des Deuterierungsgrades von deuteriertem DMSO-$d_6$ zeigt.

Fig. 7 ein $^{1}H$-NMR-Spektrum einer Mischung von DMSO-$d_6$ und $CDCl_3$ (links) und das entsprechende $^{2}H$-NMR-Spektrum (rechts) zeigt.

Beispiel 1 - Bestimmung von Natrium in Natrium Heparin

Nachfolgend wird die Bestimmung von Natrium in Natrium Heparin als ein Beispiel des erfindungsgemäßen Verfahrens. d.h. der heteronuklearen quantitativen Bestimmung, vorgestellt.

Dazu wurden bei 16 verschiedenen Proben (S1 - S16) von Na-Heparinlösungen mittels des erfindungsgemäßen Verfahrens (NMR) der Natriumgehalt bestimmt und mit den Werten verglichen, die bei einer üblicherweise hierfür verwendeten Bestimmung mittels Atomabsorptionsspektroskopie (AAS) erhalten wurden.

Zur Herstellung der Proben werden jeweils definierte Mengen an Na-Heparin eingewogen und in jeweils definierten Volumina an $D_2O$ gelöst. Die definierten Mengen an geeignetem deuteriertem Lösungsmittel können alternativ auch abgewogen werden. Alternativ zu $D_2O$ kann auch DMSO-d6 als deuteriertes Lösungsmittel verwendet werden.

Im Speziellen wurden die erfindungsgemäßen Na-Bestimmungen mittels NMR als zusätzliches Experiment im Anschluss an die in den Europäischen und US-Amerikanischen Pharmakopöen vorgeschriebenen $^{1}H$-NMR-Untersuchung durchgeführt. Dazu konnten die bereits vorhandenen Probenlösungen ohne zusätzliche Probenvorbereitung verwendet werden, so dass der zusätzliche Zeitaufwand lediglich ca. 2 Minuten pro Messung betrug.

Der Zeitbedarf für das NMR-Experiment zum Erstellen eines $^{2}H$-NMR-Spektrums betrug weniger als 10 Sekunden. Ein beispielhaftes $^{2}H$-NMR-Spektrum von Na-Heparin in $D_2O$ ist in Fig. 1 dargestellt. Erstellt wurde es mit einem 500 MHz Spektrometer vom Typ Prodigy (hergestellt von der Bruker Corporation) mit einem Puls. Das Signal/Rausch-Verhältnis S/N beträgt 17000.

Der Zeitbedarf für das NMR-Experiment zum Erstellen eines $^{23}Na$-NMR-Spektrums betrug ca. 2 Minuten. Ein beispielhaftes $^{23}Na$-NMR-Spektrum von Na-Heparin in $D_2O$ ist in Fig. 2 dargestellt. Erstellt wurde es mit demselben 500 MHz Spektrometer vom Typ Prodigy (hergestellt von der Bruker Corporation) mit 128 Pulsen. Das Signal/Rausch-Verhältnis S/N beträgt 4900.

In dem in Fig. 3 gezeigten $^{23}Na$ NMR-Spektrum sind die Na-Signale verschiedener Proben mit unterschiedlichen Konzentration an Na-Heparin überlagert dargestellt.

Anhand der Signale (Integrale) in den jeweiligen $^{2}H$-NMR- und $^{23}Na$ NMR-Spektren und unter Berücksichtigung des Kalibrierfaktors für das verwendete NMR-Spektrometer und das Nuklidpaar ($^{2}H$, $^{23}Na$) wurden die Gehalt an Na in jeder der Proben bestimmt.

Die nachfolgende Tabelle 1 zeigt die Ergebnisse, die mit dem erfindungsgemäßen Verfahren erhalten wurden, im Vergleich mit den Ergebnissen aus der Bestimmung mittels Atomabsorptionsspektroskopie (AAS).

Tabelle 1

| Probe | Gehalt an Na in der Probe [Gew.-%] | |
|---|---|---|
| | bestimmt mittels NMR | bestimmt mittels AAS |
| S1 | 10,2 | 11,9 |
| S2 | 12,4 | 12,2 |
| S3 | 13,1 | 12,0 |
| S4 | 13,1 | 11,8 |

(fortgesetzt)

| Probe | Gehalt an Na in der Probe [Gew.-%] | |
|---|---|---|
| | bestimmt mittels NMR | bestimmt mittels AAS |
| S5 | 11,3 | 12,1 |
| S6 | 12,1 | 11,6 |
| S7 | 12,9 | 12,0 |
| S8 | 13,5 | 11,6 |
| S9 | 11,6 | 11,8 |
| S10 | 12,3 | 11,5 |
| S11 | 10,5 | 11,1 |
| S12 | 11,9 | 12,0 |
| S13 | 11,4 | 11,5 |
| S14 | 11,0 | 11,6 |
| S15 | 11,9 | 11,8 |
| S15 | 11,4 | 11,6 |
| S16 | 11,1 | 11,6 |

Es zeigte sich, dass die Ergebnisse der NMR Untersuchung im Rahmen der Messgenauigkeit mir denen der klassischen AAS Methode für Na übereinstimmen.

Das vorstehend beschriebene Verfahren lässt sich problemlos auf alle andere aktiven NMR Kerne übertragen, beispielsweise auf $^{35}Cl$ oder $^{79}Br$.

Beispiel 2 - Bestimmung des Deuterierungsgrades eines NMR-Lösungsmittels

Ein für NMR-Experimente geeignetes Lösungsmittel muss einen sehr hohen Grad an Deuterium $^{2}H$ anstelle des naturgemäß häufiger vorkommenden Wasserstoffatoms $^{1}H$ enthalten. Für ein herkömmliches NMR-Experiment genügt die Angabe "sehr hoch", d.h. > 99 % D. Der Restanteil von 1% entfällt dabei auf $^{1}H$.

Für das erfindungsgemäße Verfahren der heteronuklearen quantitativen NMR ist die Kenntnis dieses Grades an Deuterierung wichtig. Im Falle sehr hoch deuterierter Lösungsmittel wie $D_2O$ mit einen Deuterierungsgrad von > 99,95 % ist der Anteil an $^{1}H$ mit 0,05 % unerheblich und spielt nur eine Rolle bei der Bestimmung der Messunsicherheit. Für die exakte Bestimmung des Deuterierungsgrades ist die NMR-Spektroskopie naturgemäß gut geeignet, da damit sowohl die Nuklide $^{2}H$ (D) als auch $^{1}H$ gemessen werden können. Das Verhältnis der Integrale D/H ist dabei direkt proportional zu dem Deuterierungsgrad. Eine notwendige Kalibrierung kann einfach über eine Zugabe desselben nicht deuterierten Lösungsmittels und eine geeignete Berechnung erfolgen.

Im Folgenden wird dies am Beispiel von deuteriertem DMSO-$d_6$ ($CD_3$-SO-$CD_3$) gezeigt. Laut Herstellerangaben beträgt der Deuterierungsgrad des im vorliegenden Beispiel verwendeten DMSO-$d_6$ ca. 99,5 %. Somit enthalten einige der DMSO-Moleküle nicht zwei identische $CD_3$-Gruppen sondern auch eine $CD_2H$- oder $CDH_2$-Gruppe. Im $^{1}H$-NMR-Spektrum lassen sich die Signale der Gruppen $CD_2H$ (Pentett durch eine $^{2}J_{D,H}$-Kopplung) und $CDH_2$ (Triplett durch $^{2}J_{D,H}$-Kopplung) getrennt darstellen (siehe Fig. 4). Im $^{2}H$-NMR Spektrum ist nur die dominante $CD_3$-Gruppe sichtbar (siehe Fig. 5).

In Fig. 4 ist auf der linken Seite ein $^{1}H$-NMR Spektrum von DMSO-$d_6$ dargestellt. In der Mitte der Fig. 4 ist in einer vertikalen Vergrößerung das Triplett der $CHD_2$-Gruppe abgebildet. Nach Zugabe von nicht deuteriertem DMSO zu dieser Probe erscheint das Singulett der $CH_3$-Gruppen zu tiefem Feld verschoben. Durch die sogenannten Deuterium Isotopeneffekte erfolgt eine äquidistante Verschiebung der $^{1}H$-Resonanzen pro Deuterium um den gleichen Betrag zu hohem Feld.

Da sich auch die $CH_3$-Gruppe am Schwefel als abgetrenntes Signal (Singulett aufgrund fehlender $^{2}J_{D,H}$) zeigt, ist hier die Verwendung von regulärem DMSO als internem Standard und zur Standard-Addition geeignet den Anteil an Protonen im DMSO-$d_6$ exakt zu bestimmen. Durch die Kenntnis des auf diese Weise sehr genau bestimmbaren Anteils an Restprotonen ist eine Kalibrierung des Verhältnisses Deuterium zu Wasserstoff zwanglos gegeben. Das auf diese Weise hinsichtlich des Deuterierungsgrades exakt definierte deuterierte Lösungsmittel kann daher im erfindungsgemäßen Verfahren als Standard bei der heteronuklearen Quantifizierung verwendet werden.

Fig. 5 zeigt auf der linken Seite ein $^2H$-NMR Spektrum von DMSO-$d_6$ und auf der rechten Seite in Vergrößerung eine Überlagerung mit dem entsprechenden $^1H$-NMR Spektrum aus Fig. 4. Das rechte Spektrum ist zur Darstellung der $^{13}C$-NMR-Satelliten vertikal vergrößert.

Nachdem dem in diesem Beispiel verwendeten deuterierten DMSO-$d_6$ verschiedene definierte Mengen an nicht deuteriertem DMSO zugegeben, die erhaltenen Mischungen jeweils NMR-spektroskopisch gemessen und die Verhältnisse der Integrale D/H bestimmt und dann die erhaltenen Verhältnisse D/H gegen die Anteil an zugegebenem nicht deuteriertem DMSO in Gew.-% aufgetragen wurden, lässt sich der Deuterierungsgrad des verwendeten deuterierten DMSO-$d_6$ anhand der linearen Korrelationsgleichung mittels folgender Gleichung (5) berechnet.

$$\text{Deuterierungsgrad} = 100 - \text{Achsenabschnitt/Steigung} \quad (5)$$

In Fig. 6 ist ein entsprechendes Diagramm mit den gemäß diesem Beispiel erhaltenen Messwerten und einer mittels linearer Regression erstellten Geraden dargestellt. Das Bestimmtheitsmaß $R^2$ betrug 0,9999. Mit der Geradengleichung y = 2,7877x + 1,194 ergibt sich demnach für das verwendete deuterierte DMSO-$d_6$ ein Deuterierungsgrad von 99,57 %.

Ein wie im obigen Beispiel 2 hinsichtlich des Deuterierungsgrades genau spezifiziertes Lösungsmittel kann nun als Universalstandard zur Bestimmung des Deuterierungsgrades anderer deuterierter Lösungsmittel wie z.B. $CDCl_3$ herangezogen werden und können somit weitere Standards für das erfindungsgemäße Verfahren (die heteronukleare Quantifizierung) spezifiziert werden.

Dazu mischt man das zu hinsichtlich des Deuterierungsgrades zu spezifizierende Lösungsmittel mit dem zuvor definierten DMSO-$d_6$ und führt entsprechende $^1H$- und $^2H$-NMR-spektroskopische Messungen durch. Eine Kenntnis der Mischungsverhältnisse ist dabei nicht nötig, da alle die Messung beeinflussenden Parameter wie Menge, individuelle Instrumenteneinstellungen etc. relativiert werden. Diese Vorgehensweise wird im folgenden Beispiel 3 näher erläutert.

<u>Beispiel 3</u> - Bestimmung des Deuterierungsgrades eines NMR-Lösungsmittels unter Verwendung eines anderen deuterierten Lösungsmittels mit bekanntem Deuterierungsgrad

Im vorliegenden Beispiel 3 wird der Deuterierungsgrad von deuteriertem $CDCl_3$ bestimmt. Dazu wird eine Mischung des deuterierten $CDCl_3$ mit dem in Beispiel 2 verwendeten DMSO-$d_6$ (Deuterierungsgrad 99,57 %) in einem ungefähren Mischungsverhältnis von 1:1 hergestellt. Da das Mischungsverhältnis nicht genau bekannt sein muss, kann es gewichtsbezogen oder auch volumenbezogen sein. Es können auch andere Mischungsverhältnisse verwendet werden solange aussagekräftige NMR-Spektren erhalten werden können. Die erhaltene Mischung wird mittels $^2H$- und $^1H$-NMR (je ein einziger Puls) gemessen.

Fig. 7 zeigt auf der linken Seite ein $^1H$-NMR-Spektrum der hergestellten Mischung von DMSO-$d_6$ und $CDCl_3$ und zeigt auf der rechten Seite das entsprechende $^2H$-NMR-Spektrum.

Das Verhältnis der Integrale D/H aus den Spektren von DMSO-$d_6$ wird mit dem Verhältnis der Integrale D/H aus den Spektren von $CDCl_3$ verglichen und unter Berücksichtigung des bekannten Protonierungsgrades ($\{H\}_{DMSO}$ von DMSO-$d_6$ der Protonierungsgrad und der Deuterierungsgrad des $CDCl_3$ berechnet. Tabelle 2 zeigt die entsprechenden Messwerte und Berechnungsergebnisse.

Tabelle 2

| | Integral IntD aus $^2H$-NMR-Spektrum | Integral IntH aus $^1H$-NMR-Spektrum | Verhältnis IntD/IntH | Protonierungsgrad {H} in % | Deuterierungsgrad {D} in % |
|---|---|---|---|---|---|
| DMSO | 86,95 | 94,45 | 0,92 | 0,43 | 99,57 |
| Chloroform | 13,05 | 5,55 | 2,35 | 0,17 | 99,83 |

Der Deuterierungsgrad $\{D\}_{CDCl3}$ in % des Chloroforms lässt sich anhand folgender Gleichung (6) berechnen:

$$\{D\}_{CDCl3} = 100 - (\{H\}_{DMSO} \times (IntH_{DMSO} / IntD_{DMSO}) / (IntH_{CDCl3} / IntD_{CDCl3}) \quad (6)$$

Für das deuterierte Chloroform ergibt sich demnach ein Deuterierungsgrad von 99,83 %.

## Patentansprüche

1. Verfahren zur quantitativen Bestimmung eines Analyten in einem Prüfgegenstand unter Verwendung eines NMR-Spektrometers, mit den Schritten:

    Bereitstellen einer Probenlösung durch Lösen einer definierten Menge des Prüfgegenstands in einer definierten Menge eines deuterierten Lösungsmittels,
    Kalibrieren des NMR-Spektrometers durch Bestimmen eines Kalibrierfaktors bezogen auf ein erstes und ein zweites NMR-aktives Nuklid, wobei das erste NMR-aktive Nuklid Bestandteil des deuterierten Lösungsmittels ist und das zweite NMR-aktive Nuklid Bestandteil des Analyten ist;
    Erstellen eines ersten Spektrums durch Durchführen eines ersten NMR-Experiments an der Probenlösung zur Bestimmung der Resonanzfrequenzen des ersten NMR-aktiven Nuklids;
    Erstellen eines zweiten Spektrums durch Durchführen eines zweiten NMR-Experiments an der Probenlösung zur Bestimmung der Resonanzfrequenzen des zweiten NMR-aktiven Nuklids, und
    Berechnen der Masse an Analyt in der Probenlösung unter Berücksichtigung der Signale im ersten und zweiten Spektrum und unter Berücksichtigung des Kalibrierfaktors,

        wobei das erste NMR-aktive Nuklid und das zweite NMR-aktive Nuklid voneinander verschieden sind,
        der Kalibrierfaktor bestimmt wird durch Bestimmen der Resonanzfrequenzen des ersten NMR-aktiven Nuklids und des zweiten NMR-aktiven Nuklids in einer Kalibrierlösung, die bekannte Mengen des ersten NMR-aktiven Nuklids und des zweiten NMR-aktiven Nuklids enthält, Erstellen zweier Kalibrierspektren und Vergleich der Signale des ersten NMR-aktiven Nuklids und des zweiten NMR-aktiven Nuklids in den Kalibrierspektren und
        das erste und das zweite NMR-Experiment und die Bestimmung des Kalibrierfaktors unter Verwendung desselben NMR-Spektrometers durchgeführt werden.

2. Verfahren nach Anspruch 1, wobei das erste NMR-aktive Nuklid $^{2}H$ ist.

3. Verfahren nach Anspruch 1 oder 2, wobei das deuterierte Lösungsmittel mindestens eines ist ausgewählt aus $D_2O$, DMSO-$d_6$, $CDCl_3$, Aceton-$d_6$, Acetonitril-$d_3$ und Benzol-$d_6$.

4. Verfahren nach einem der vorhergehenden Ansprüche, wobei die Probenlösung in einem für die NMR-Messung geeigneten Behälter wie beispielsweise einem NMR-Röhrchen bereitgestellt wird.

5. Verfahren zur Bestimmung des Deuterierungsgrades einer ersten deuterierten Verbindung mit den Schritten:

    Herstellen einer Mischung aus der ersten deuterierten Verbindung und einer zweiten deuterierten Verbindung deren Deuterierungsgrad bekannt ist, so dass beide deuterierten Verbindungen gelöst vorliegen;
    Erstellen eines $^{1}H$-NMR-Spektrums von der Mischung und Bestimmen der Integrale von mindestens einem Peak von jeder der beiden deuterierten Verbindungen;
    Erstellen eines $^{2}H$-NMR-Spektrums von der Mischung und Bestimmen der Integrale derselben Peaks;
    Berechnen des Deuterierungsgrades der ersten deuterierten Verbindung anhand der bestimmten Integralwerte und dem bekannten Deuterierungsgrad der zweiten deuterierten Verbindung.

6. Verfahren nach Anspruch 5, wobei mindestens eine der ersten und zweiten deuterierten Verbindungen ein deuteriertes Lösungsmittel für die NMR-Spektroskopie ist.

## Claims

1. A method for quantitative determination of an analyte in a test item using a NMR spectrometer, the method comprises the steps:

    providing a sample solution by dissolving a defined amount of the test item in a defined amount of a deuterated solvent,
    calibrating the NMR spectrometer by determining a calibration factor related to a first and a second NMR-active nuclide, wherein the first NMR-active nuclide is a constituent of the deuterated solvent and the second NMR-active nuclide is a constituent of the analyte;

generating a first spectrum by performing a first NMR experiment on the sample solution to determine the resonance frequencies of the first NMR-active nuclide;
generating a second spectrum by performing a second NMR experiment on the sample solution to determine the resonance frequencies of the second NMR-active nuclide, and
calculating the mass of analyte in the sample solution taking into account the signals in the first and second spectra and taking into account the calibration factor,

wherein the first NMR-active nuclide and the second NMR-active nuclide are different from each other,
the calibration factor is determined by determining the resonant frequencies of the first NMR-active nuclide and the second NMR-active nuclide in a calibration solution containing known amounts of the first NMR-active nuclide and the second NMR-active nuclide, generating two calibration spectra and comparing the signals of the first NMR-active nuclide and the second NMR-active nuclide in the calibration spectra, and
the first and the second NMR experiments and the determination of the calibration factor are carried out using the same NMR spectrometer.

**2.** The method according to claim 1, wherein the first NMR-active nuclide is $^2H$.

**3.** The method according to claim 1 or 2, wherein the deuterated solvent is at least one selected from $D_2O$, DMSO-$d_6$, $CDCl_3$, acetone-$d_6$, acetonitrile-$d_3$ and benzene-$d_6$.

**4.** The method according to any of the preceding claims, wherein the sample solution is provided in a container suitable for NMR measurement, such as a NMR tube.

**5.** A method for determining the degree of deuteration of a first deuterated compound, the method comprises the steps:

preparing a mixture of the first deuterated compound and a second deuterated compound whose degree of deuteration is known, so that both deuterated compounds are dissolved;
generating a $^1H$ NMR spectrum from the mixture and determining the integrals of at least one peak of each of the two deuterated compounds;
generating a $^2H$ NMR spectrum from the mixture and determining the integrals of the same peaks;
calculating the degree of deuteration of the first deuterated compound using the determined integral values and the known degree of deuteration of the second deuterated compound.

**6.** The method according to claim 5, wherein at least one of the first and second deuterated compounds is a deuterated solvent for NMR spectroscopy.

## Revendications

**1.** Procédé de détermination quantitative d'un analyte dans un objet de test en utilisant un spectromètre RMN, comprenant les étapes consistant à :

fournir une solution d'échantillon en dissolvant une quantité définie de l'objet de test dans une quantité définie d'un solvant deutéré,
étalonner le spectromètre RMN en déterminant un facteur d'étalonnage par rapport à des premier et second nucléides actifs en RMN, dans lequel le premier nucléide actif en RMN est un constituant du solvant deutéré et le second nucléide actif en RMN est un constituant de l'analyte ;
créer un premier spectre en mettant en œuvre une première expérience de RMN sur la solution d'échantillon afin de déterminer les fréquences de résonance du premier nucléide actif en RMN ;
créer un second spectre en mettant en œuvre une seconde expérience de RMN sur la solution d'échantillon afin de déterminer les fréquences de résonance du second nucléide actif en RMN, et
calculer la masse d'analyte dans la solution d'échantillon en tenant compte des signaux dans les premier et second spectres et en tenant compte du facteur d'étalonnage,
dans lequel le premier nucléide actif en RMN et le second nucléide actif en RMN sont différents l'un de l'autre,
le facteur d'étalonnage est déterminé en déterminant les fréquences de résonance du premier nucléide actif en RMN et du second nucléide actif en RMN dans une solution d'étalonnage contenant des quantités connues du premier nucléide actif en RMN et du second nucléide actif en RMN, en créant deux spectres d'étalonnage et en comparant les signaux du premier nucléide actif en RMN et du second nucléide actif en RMN dans les

spectres d'étalonnage, et
les première et seconde expériences de RMN et la détermination du facteur d'étalonnage sont mises en œuvre en utilisant le même spectromètre RMN.

**2.** Procédé selon la revendication 1, dans lequel le premier nucléide actif en RMN est $^{2}H$.

**3.** Procédé selon la revendication 1 ou 2, dans lequel le solvant deutéré est au moins un solvant choisi parmi $D_2O$, DMSO-$d_6$, $CDCl_3$, acétone-$d_6$, acétonitrile-$d_3$ et benzène-$d_6$.

**4.** Procédé selon l'une quelconque des revendications précédentes, dans lequel la solution d'échantillon est fournie dans un récipient approprié pour la mesure RMN, tel qu'un tube RMN.

**5.** Procédé de détermination du degré de deutération d'un premier composé deutéré, comprenant les étapes consistant à :

préparer un mélange à partir du premier composé deutéré et d'un second composé deutéré dont le degré de deutération est connu, de sorte que les deux composés deutérés sont dissous ;
créer un spectre RMN $^{1}H$ du mélange et déterminer les intégrales d'au moins un pic de chacun des deux composés deutérés ;
créer un spectre RMN $^{2}H$ du mélange et déterminer les intégrales des mêmes pics ;
calculer le degré de deutération du premier composé deutéré à l'aide des valeurs d'intégrale déterminées et du degré de deutération connu du second composé deutéré.

**6.** Procédé selon la revendication 5, dans lequel au moins un parmi les premier et second composés deutérés est un solvant deutéré destiné à la spectroscopie RMN.

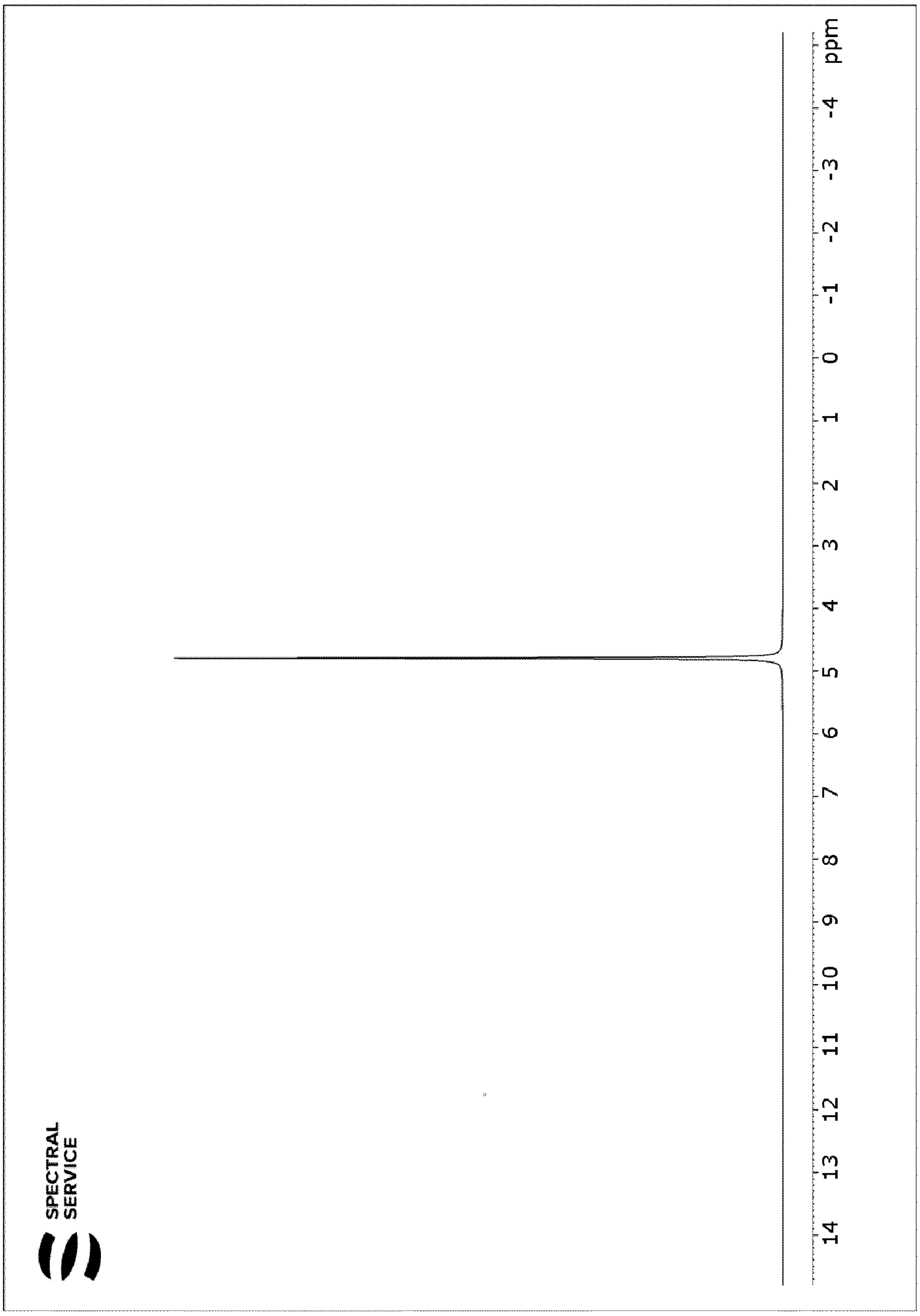


Fig. 1

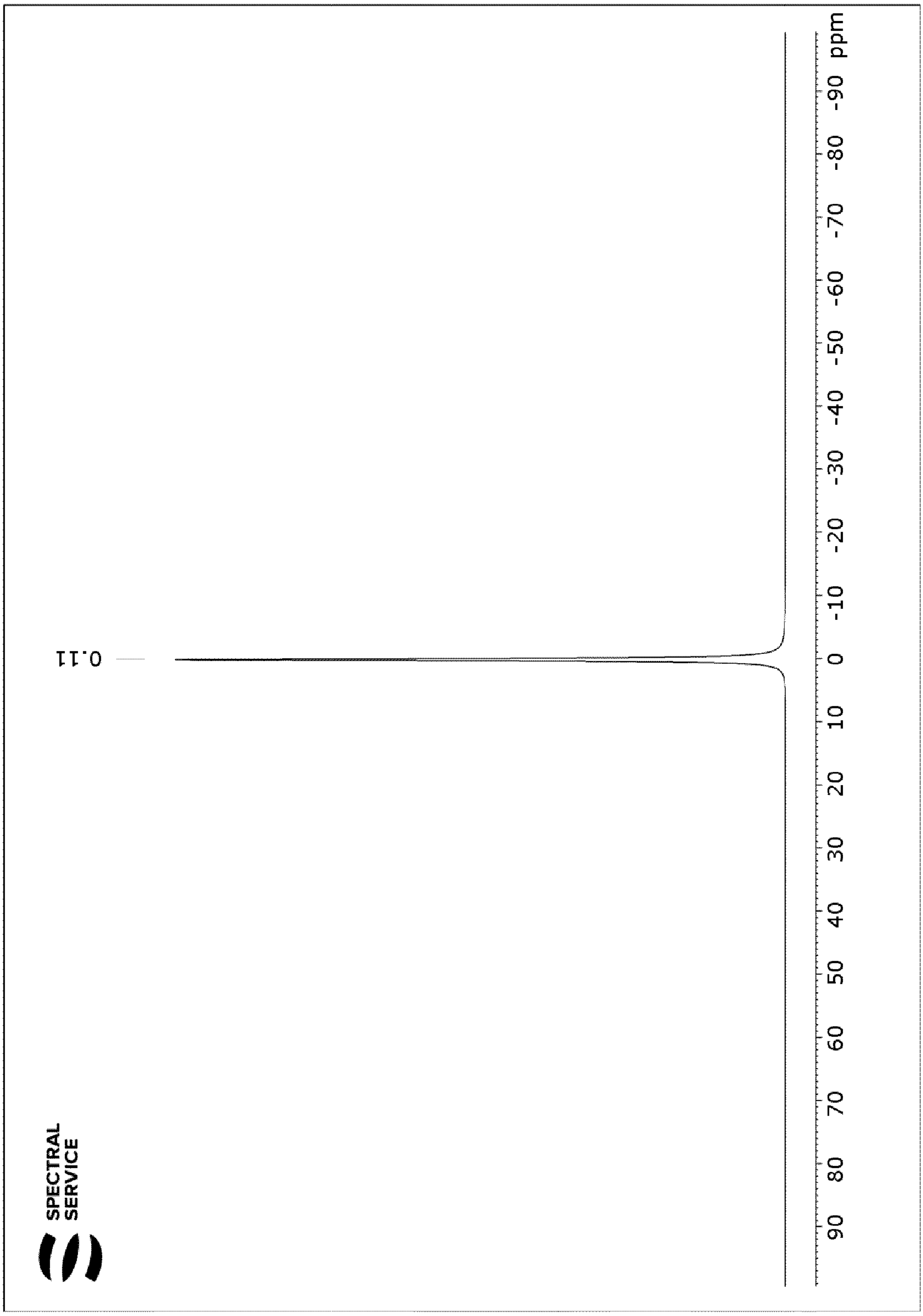
0.11
ppm
-90 -80 -70 -60 -50 -40 -30 -20 -10 0 10 20 30 40 50 60 70 80 90
SPECTRAL SERVICE

Fig. 2

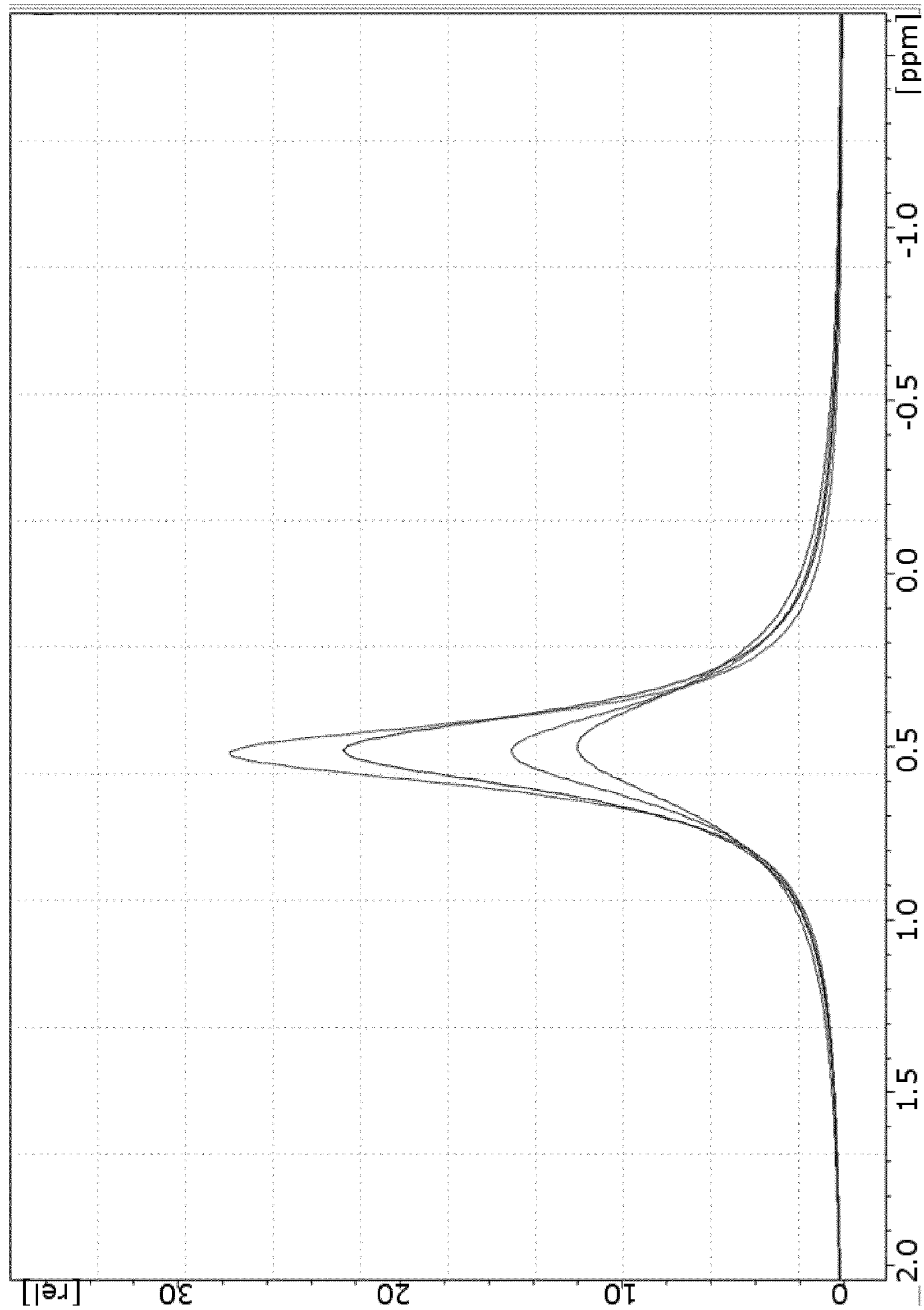


Fig. 3

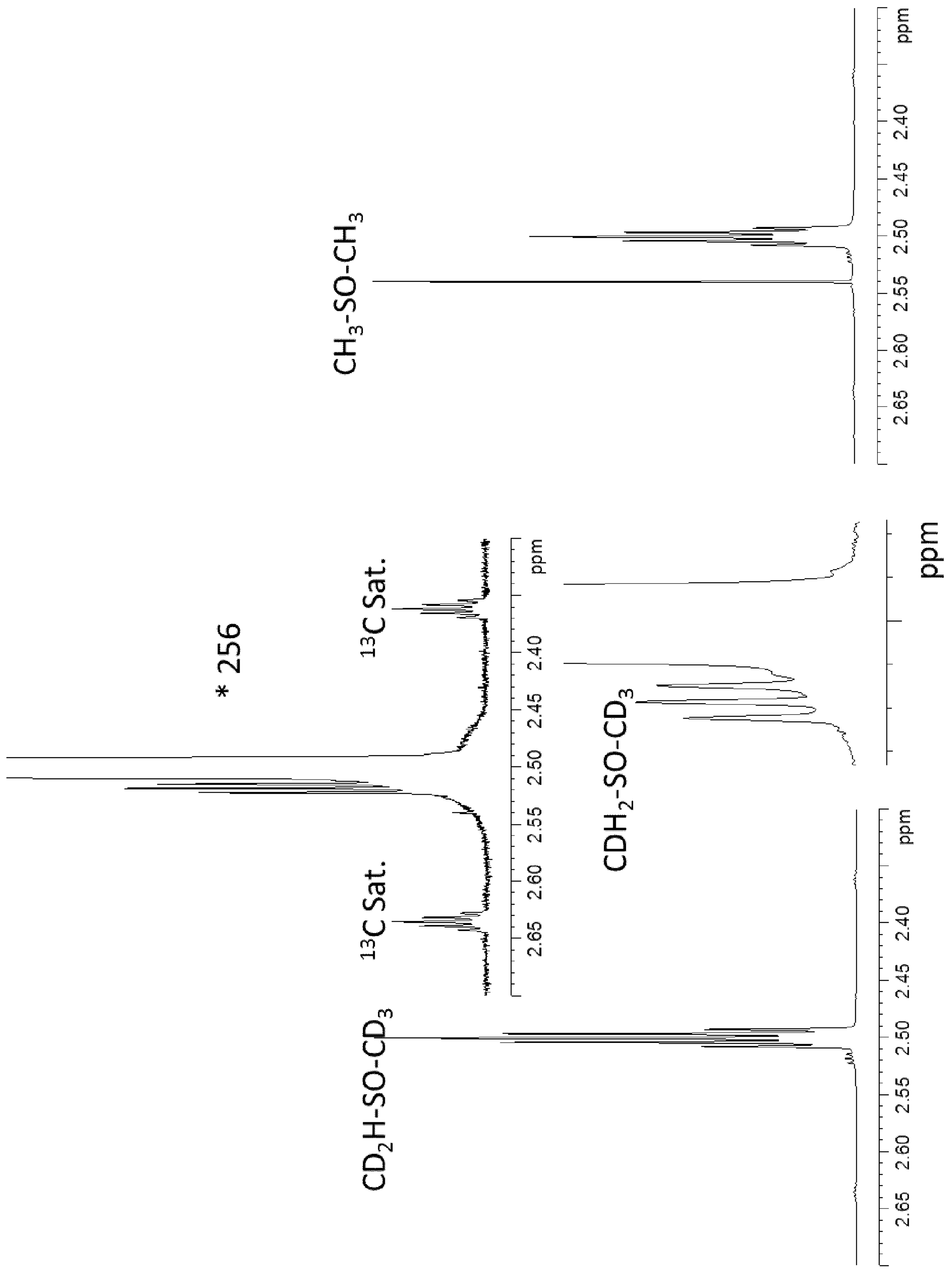


**Fig. 4**

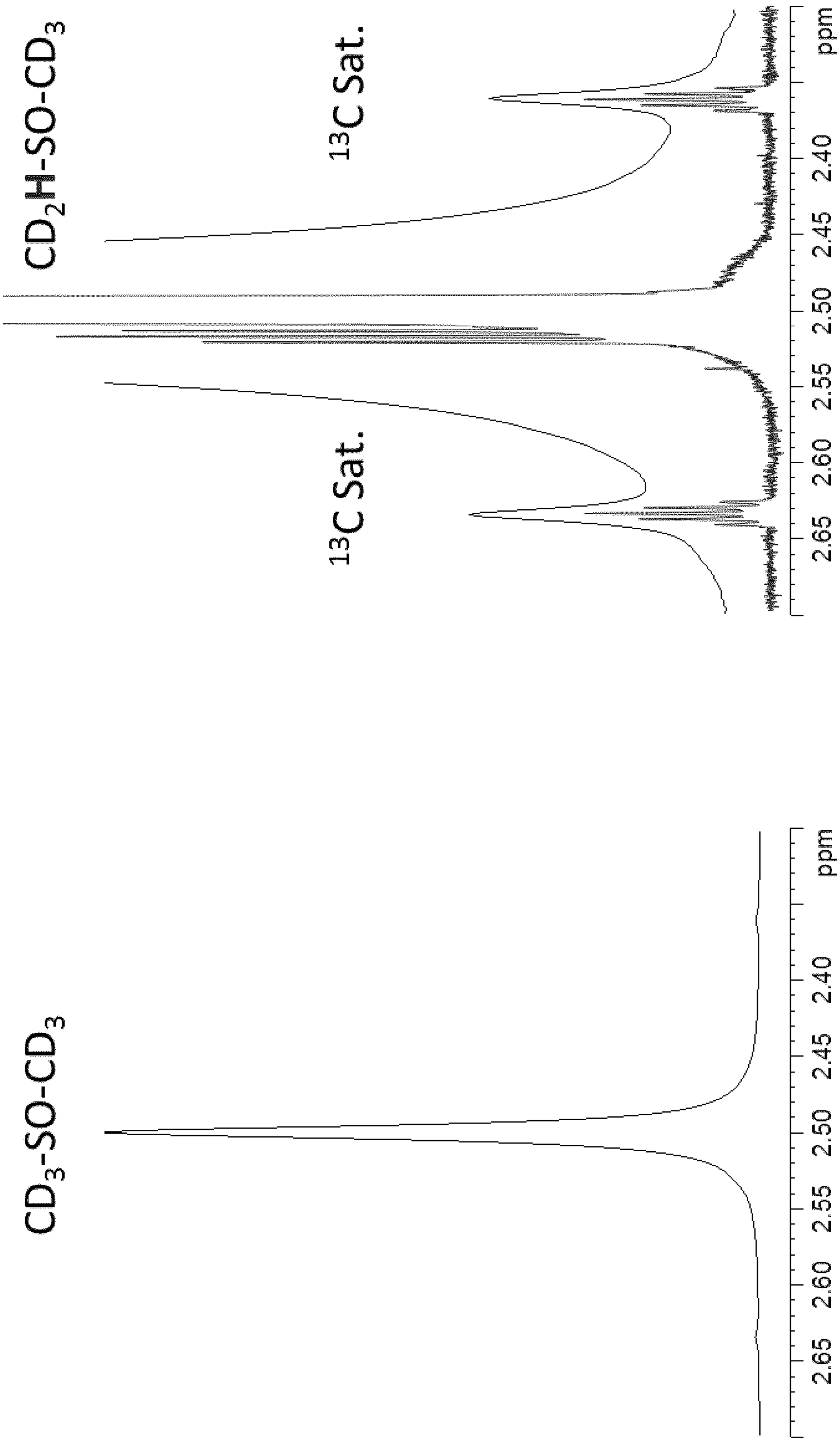
CD2H-SO-CD3
13C Sat.
13C Sat.
CD3-SO-CD3
ppm
2.40
2.45
2.50
2.55
2.60
2.65

**Fig. 5**

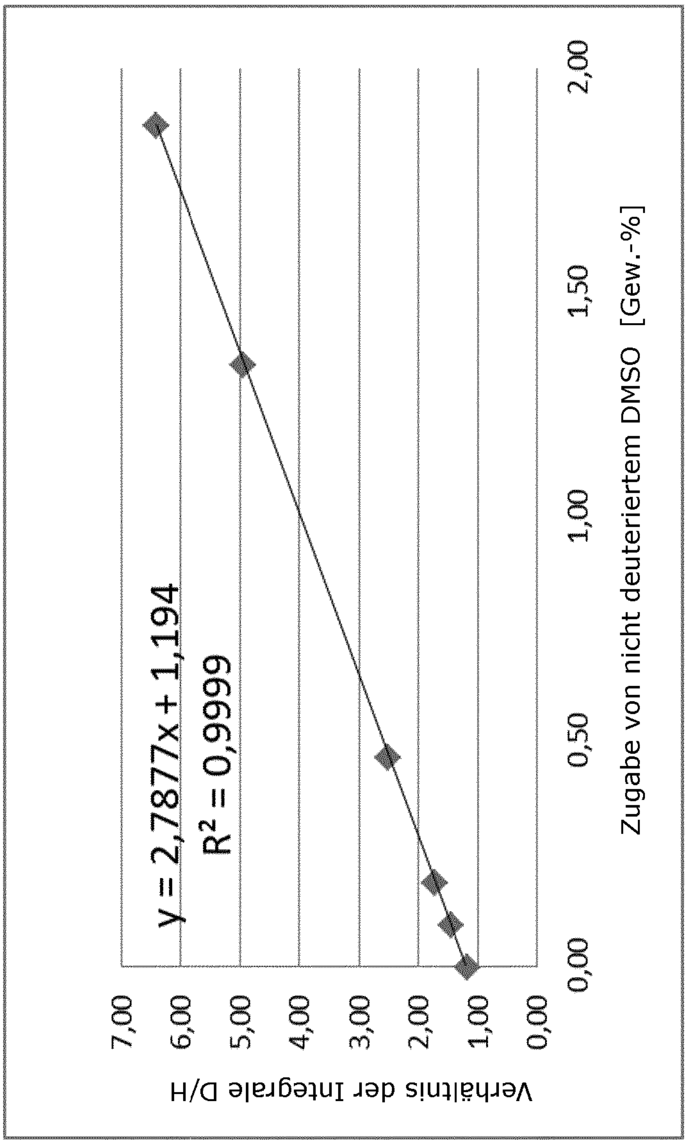
y = 2,7877x + 1,194
R² = 0,9999
Verhältnis der Integrale D/H
7,00
6,00
5,00
4,00
3,00
2,00
1,00
0,00
0,00
0,50
1,00
1,50
2,00
Zugabe von nicht deuteriertem DMSO [Gew.-%]

Fig. 6

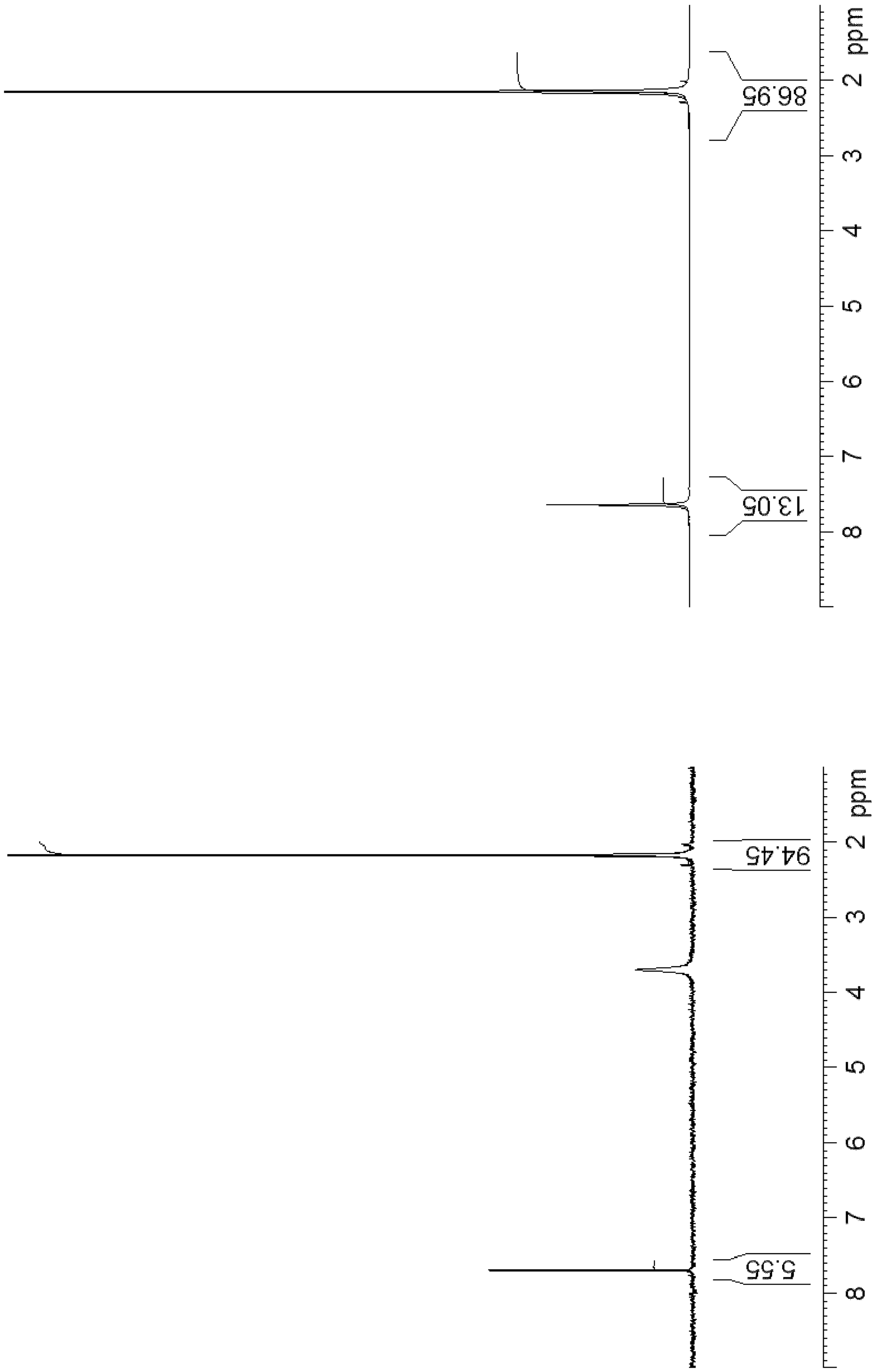


Fig. 7

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102012204701 A1
- DE 102012224334 B4

### In der Beschreibung aufgeführte Nicht-Patentliteratur

- **SANTOSH KUMAR BHARTI ; RAJA ROY.** Quantitative H NMR spectroscopy. *Trends in Analytical Chemisrty,* 2012, vol. 35, 5-26